(19) Europäisches Patentamt
European Patent Office
Office européen des brevets

(11) **EP 2 206 016 B1**

(12) **FASCICULE DE BREVET EUROPEEN**

(45) Date de publication et mention
de la délivrance du brevet:
**20.07.2016 Bulletin 2016/29**

(21) Numéro de dépôt: **08843391.7**

(22) Date de dépôt: **13.10.2008**

(51) Int Cl.:
***G03F 7/00*** *(2006.01)*

(86) Numéro de dépôt international:
**PCT/EP2008/063739**

(87) Numéro de publication internationale:
**WO 2009/056440 (07.05.2009 Gazette 2009/19)**

(54) **DISPOSITIF, PROCÉDÉS DE MICROTAMPONNAGE ET TAMPON POUR CE DISPOSITIF**

PAD-MIKRODRUCKEINRICHTUNG UND  VERFAHREN UND PAD FÜR DIESE EINRICHTUNG

PAD MICROPRINTING DEVICE AND METHODS, AND PAD FOR THIS DEVICE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **31.10.2007  FR 0707691**

(43) Date de publication de la demande:
**14.07.2010  Bulletin 2010/28**

(73) Titulaires:
• **Ecole Centrale de Lyon**
**69134 Ecully (FR)**
• **Centre National de la Recherche Scientifique**
**75016 Paris (FR)**

(72) Inventeurs:
• **CABRERA, Michel**
**F-69008 Lyon (FR)**
• **BOU CHAKRA, Elie**
**F-69007 Lyon (FR)**

(74) Mandataire: **Colombo, Michel et al**
**Brevinnov**
**310 avenue Berthelot**
**69008 Lyon (FR)**

(56) Documents cités:
EP-A- 1 726 991    WO-A-97/06012
WO-A-02/067055    WO-A-2006/096123

**Description**

L'invention concerne un dispositif de microtamponnage, un tampon pour ce dispositif et des procédés de microtamponnage.

Les dispositifs de microtamponnage comprennent un substrat et un tampon propre à imprimer une empreinte sur une face de ce substrat.

Le déposant connaît des tampons comprenant :

- une couche en matériau élastomère présentant un premier fond plat à partir duquel font saillie $\underline{n}$ niveaux successifs de motifs en relief classés par ordre décroissant de hauteur $h_i$, où $\underline{n}$ est un entier supérieur ou égal à deux et l'indice $\underline{i}$ représente le niveau de motif avec i égal à un pour le motif dont la hauteur $h_i$ est la plus grande,

- un premier niveau de motif, dit de conformation, permettant de paralléliser grossièrement le premier fond plat avec la face du substrat, ce motif étant composé de plusieurs plots de hauteur $h_1$, ces plots définissant au moins trois points d'appui non colinéaires sur ladite face et autour du premier fond plat, la hauteur $h_1$ étant mesurée par rapport à ce premier fond plat et dans une direction perpendiculaire à ce premier fond plat, et

- un n-ième niveau de motif, dit d'impression, apte à venir en contact avec la face du substrat, uniquement après que le (n-1)-ième niveau de motif ait été mis en contact avec cette face, pour imprimer l'empreinte sur la face du substrat, ce motif étant composé d'un ou plusieurs plots de hauteur $h_n$ faisant saillie perpendiculairement à partir d'un n-ième fond plat confondu avec ou parallèle au premier fond plat et situé entre les trois points d'appui du premier niveau de motif, la hauteur $h_n$ étant comprise entre $0,5 \times SFQR_{max}$ et $h_{n-1}/2$, où $SFQR_{max}$ (Max Site Frontside least sQuare focal plane Range) est une mesure normalisée de la planéité du substrat, la hauteur $h_n$ de chaque plot étant mesurée par rapport au n-ième fond plat et perpendiculairement à ce n-ième fond plat,

Les mesures de la planéité du substrat telles que les mesures GBIR (Global Backside Ideal focal plane Range), $SBIR_{max}$ (Max Site Backside Ideal focal plane Range) et $SFQR_{max}$ sont définies dans les normes DIN 50441-1, SEMI MF1530 et SEMI M1. Seule une brève description de ces mesures est donnée ici. Pour plus d'informations, le lecteur peut se reporter au texte de ces normes.

La mesure GBIR ou TTV (Total Thickness Variation) est définie à l'aide de la relation suivante :

$$GBIR = d_{max} - d_{min}$$

où :

- $d_{max}$ et $d_{min}$ sont, respectivement, les épaisseurs maximale et minimale du substrat mesurées par rapport à un plan de référence.

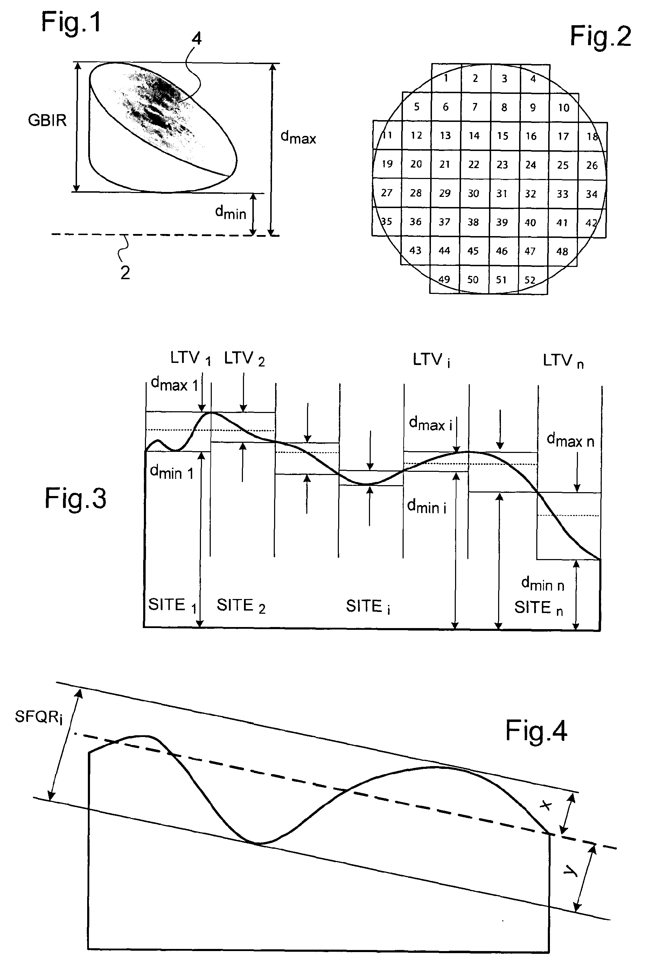

La mesure GBIR, est représentée sur la figure 1. Sur cette figure le plan de référence est constitué par un fond plat 2 sur lequel est maintenu le substrat. Le fond 2 est représenté par une ligne en pointillés. Une portion 4 de la surface supérieure du substrat est également illustrée.

La mesure SBIR ou LTV est une mesure locale de la planéité du substrat. Pour cette mesure, la surface du substrat est divisée en sites, La figure 2 représente un exemple de substrat 6 dont la surface est divisée en 52 sites. Par exemple, le substrat 6 est une tranche de silicium plus connue sous le terme anglais de « wafer ». Ici, chaque site est un carré de 20 mm de côté.

Pour chaque site i, la mesure $SBIR_i$, est donnée par la relation suivante

$$SBIR_i = d_{maxi} - d_{mini}$$

où:

$d_{maxi}$ et $d_{mini}$ sont, respectivement, les épaisseurs maximale et minimale du substrat au niveau du site par rapport à un plan de référence constitué ici par le fond du substrat.

Les épaisseurs $d_{mini}$ et $d_{maxi}$ sont représentées pour $\underline{n}$ sites sur la figure 3.

La mesure $SBIR_{max}$ est donnée par la relation suivante :

$$SBIR_{max} = max[SBIR_1, SBIR_2, ..., SBIR_i, ...,SBIR_n].$$

Enfin, la mesure SFQR$_i$ (Site Frontside least sQuare focal plane Range) est une mesure locale, sur le site i, de la planéité de la surface du substrat. Cette mesure SFQR$_i$ est donnée par la relation suivante :

$$SFQR_i = |x| + |y|$$

ou:

- |x| est la valeur absolue du dépassement maximal par rapport à un plan de référence connu sous le terme de « focal plane », et
- |y| est la valeur absolue de la profondeur du creux le plus important par rapport au plan de référence,

Par exemple, la position du plan de référence est déterminée par la méthode des moindres carrés pour minimiser les écarts de la surface du substrat par rapport à ce plan,

Pour illustre la définition des valeurs x et y, celles-ci sont représentées pour un seul site ! sur la figure 4. Sur cette figure, le plan de référence est représenté par une ligne en pointillés.

La mesure SFQR$_{max}$ est donnée par la relation suivante :

$$SFQR_{max} = max[SFQR_1, SFQR_2, ..., SFQR_i, ..., SFQR_n].$$

On définit également par l'expression « fond plat » une surface lisse ne présentant pas d'aspérités dont la hauteur est supérieure à $h_n/10$ à l'exception des motifs en relief qui ont volontairement été construits sur ce fond.

Des dispositifs de microtamponnage sont divulgués dans WO97/06012 EP 1 726 991 et WO02/067055

Un tampon multniveau est divulgué dans le brevet US 5 817 242 (voir figure 8), Dans ce document, le tampon comporte uniquement un premier niveau de motif de conformation et un niveau de motif d'impression. Les plots du premier niveau de motif sont réalisés en matériaux élastomères et plus précisément en PDMS (poly(diméthylsiloxane)). Par contre, le motif d'impression est réalisé dans un matériau beaucoup plus dur, c'est-à-dire en PMMA (poly(méthacrylate de méthyle))). Le module de Young du PMMA est compris entre 1,8 et 3,1 GPa. L'utilisation du PMMA permet d'empêcher l'écrasement des plots du motif d'impression lors du tamponnage. En effet, un écrasement excessif des plots du motif d'impression conduit à une empreinte illisible.

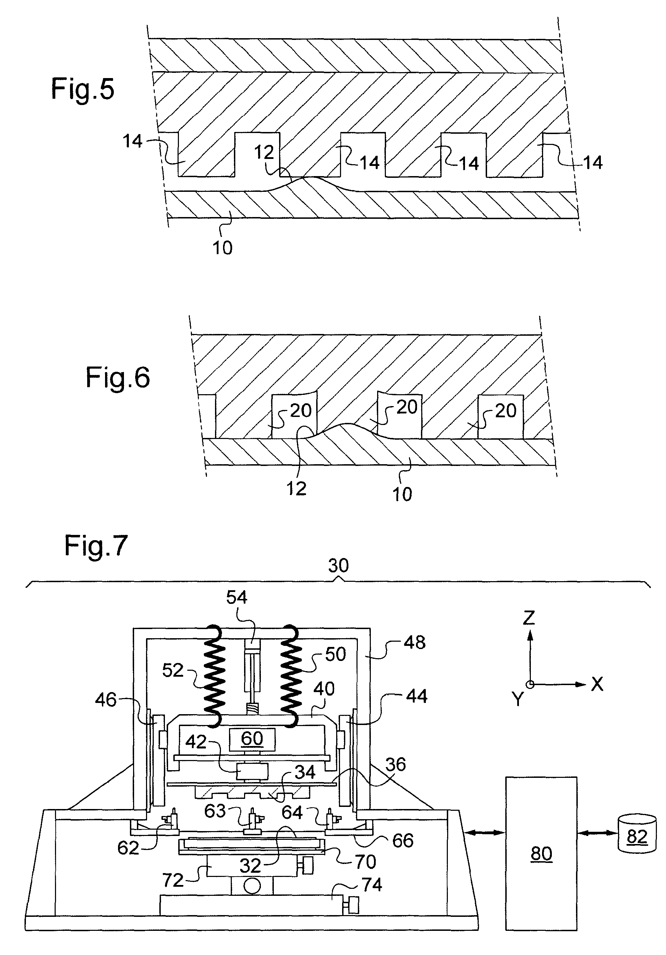

Toutefois, la dureté des plots du motif d'impression introduit de nouveaux problèmes. Par exemple, ce tampon est extrêmement sensible à un défaut local de planéité du substrat telle qu'une bosse. Un exemple de cette situation est représenté sur la figure 5. Sur la figure 5, un substrat 10 présente une bosse 12. Quelques plots 14 du motif d'impression en PMMA du tampon sont représentés. Comme illustré sur cette figure, à cause de la dureté du PMMA la bosse 12 du substrat empêche un grand nombre de plots de venir en contact avec la face du substrat. Ainsi, la qualité de l'empreinte réalisée avec ce tampon est très sensible à la présence de défauts locaux de planéité, en particulier des défauts submicrométriques.

L'invention vise à remédier à cet inconvénient en proposant un dispositif de microtamponnage moins sensible aux défauts locaux de planéité de ce substrat Elle a donc pour objet un dispositif de microtamponnage conforme à la revendication 1.

Grâce au tampon ci-dessus, comme l'illustre la figure 6, lorsque le motif d'impression est appliqué contre la même bosse 12 que celle décrite en regard de la figure 5, le motif d'impression, qui est en élastomère au lieu de PMMA, se déforme localement ce qui permet d'appliquer sur le substrat des plots 20 qui se trouvent à droite et à gauche de la bosse 12. Sur la figure 6, seul le motif d'impression a été représenté. L'écrasement du motif d'impression est évité grâce au mécanisme de butée qui permet de contrôler la charge exercée sur le tampon pendant le contact avec une très grande résolution en empêchant l'écrasement de ce motif sur plus de la moitié de sa hauteur $h_n$. Ainsi, le dispositif de microtamponnage décrit ici est moins sensible aux défauts locaux de planéité du substrat, De plus, ce tampon permet de réaliser des empreintes submicrométriques de manière plus contrôlée qu'avec le tampon décrit dans US 5 817 242, qui ne repose que sur la rigidité du motif d'impression pour éviter son écrasement lors du tamponnage,

Dans la pratique, il est particulièrement avantageux d'utiliser des tampons multiniveaux, en ajoutant des niveaux de motifs de conformation supplémentaires par rapport au motif d'impression de niveau n, à des hauteurs supérieures $h_i$ avec i = 1 à n-1, En effet, comme expliqué plus loin, ces motifs supplémentaires facilitent le réglage du dispositif de microtamponnage et la mise en oeuvre du procédé.

**EP 2 206 016 B1**

D'autres modes de réalisation de ce dispositif de microtamponnage apparaissent dans les revendications dependantes.

Ces modes de réalisation du dispositif de microtamponnage présentent en outre les avantages suivants :

- pouvoir arrêter le tampon dans une position où seul un ou plusieurs motifs de conformation sont en contact avec le substrat permet de laisser le temps au tampon de se déformer avant de procéder à l'impression de l'empreinte sur la face du substrat par le motif d'impression,
- la présence d'au moins trois butées motorisées dont les hauteurs sont réglables indépendamment l'une de l'autre permet d'ajuster l'inclinaison globale du tampon par rapport à la face du substrat,
- l'utilisation d'un capteur d'écart et le réglage automatique de la hauteur des butées en fonction des données transmises par ce capteur permet de régler automatiquement l'inclinaison du tampon par rapport à la face du substrat, et
- l'utilisation de butées réglables entre le porte-tampon et le tampon ou entre le porte-substrat et le substrat permet de rattraper des défauts locaux de planéité du substrat ou du tampon.

L'invention a également pour objet un tampon destiné à être mis en oeuvre dans le dispositif de microtamponnage dessus

Des modes de réalisation de ce tampon apparaissent dans les revendications dépendantes.

Les modes de réalisation de ce tampon présentent en outre les avantages suivants :

- l'utilisation d'un niveau intermédiaire de motif de conformation permet d'améliorer le parallélisme entre le $(n-1)$-ième fond plat et la face du substrat ce qui en fin de compte améliore la netteté de l'empreinte,
- la présence de canaux d'échappement permet d'empêcher l'emprisonnement de bulles d'air entre le tampon et le substrat, ce qui améliore la qualité de l'empreinte,
- des motifs d'impression dont la hauteur $h_n$ est inférieure au micromètre permettent de réaliser une empreinte comportant des motifs dont la plus petite largeur est inférieure au micromètre.

L'invention a également pour objet un procédé d'impression sans contact conforme à la revendication 10.

Dans le procédé ci-dessus, puisque l'épaisseur $D_n$ est comprise entre $h_n + 1$ nm et $h_n$ +100 nm, le motif d'impression est maintenu au-dessus de la face du substrat à une distance comprise entre 1 nm et 100 nm. Cette distance est suffisamment petite pour permettre à l'encre qui recouvre le motif d'impression de traverser cette espace d'épaisseur $D_n$, enfin de former l'empreinte sur la face du substrat. Toutefois, dans ce mode de réalisation, étant donné que les plots du motif d'impression n'entrent pas directement en contact avec la face du substrat, ceux-ci ne sont pas déformés, ce qui améliore la qualité de l'empreinte réalisée.

L'invention a également pour objet un procédé d'impression d'une empreinte conforme à la revendication 11.

Des modes de réalisation de ce procédé apparaissent dans les revendications dépendantes.

Ces modes de réalisation du procédé de microtamponnage présentent en outre les avantages suivants ;

- arrêter le mouvement du tampon alors que seule une partie des niveaux de motif de conformation est directement en appui sur la face du substrat permet de laisser du temps pour que le tampon se déforme avant de procéder à un écrasement supplémentaire de ce tampon ce qui, en fin de compte, améliore la qualité de l'empreinte,
- ajuster les butées afin d'améliorer le parallélisme entre un niveau de motif et la face du substrat avant de procéder à un écrasement supplémentaire du tampon permet d'améliorer la qualité de l'empreinte obtenu.
- le réglage de la hauteur de chaque butée en fonction de la détection ou de la mesure des écarts entre les plots et la face du substrat permet de régler automatiquement la hauteur des butées pour ajuster le parallélisme entre le tampon et la face du substrat avant de procéder à un écrasement supplémentaire de ce tampon,

L'invention sera mieux comprise à la lecture de la description qui va suivre, donnée uniquement à titre d'exemple non limitatif et faite en se référant aux dessins sur lesquels,

- la figure 1 est une illustration schématique de la mesure GBIR,
- la figure 2 est une illustration schématique de la décomposition de la surface d'un substrat en plusieurs sites,
- la figure 3 est une illustration schématique de la mesure SBIR,
- la figure 4 est une illustration schématique des mesure $SFQR_i$ sur un site particulier du substrat,
- la figure 5 est une illustration schématique et partielle d'un tampon de l'état de la technique,
- la figure 6 est une illustration schématique et partielle d'un motif d'impression réalisé en matériau élastomère,
- la figure 7 est une illustration schématique de la structure d'un dispositif de microtamponnage,
- la figure 8 est une illustration plus détaillée en trois dimensions d'une articulation utilisée dans le dispositif de la figure 7,

- la figure 9 est une illustration schématique d'un capteur d'écart utilisé dans le dispositif de la figure 7,
- la figure 10 est une illustration en vue de dessus du positionnement de butées motorisées utilisées dans le dispositif de la figure 7,
- la figure 11 est une illustration schématique et en coupe verticale d'un tampon multiniveau utilisé dans le dispositif de la figure 7,
- la figure 12 est un organigramme d'un procédé de microtamponnage à l'aide du dispositif de la figure 7,
- les figures 13 à 18 sont des illustrations schématiques de certaines étapes particulières du procédé de la figure 12,
- les figures 19 à 22 représentent différents autres modes de réalisation possibles d'un tampon multiniveau utilisable dans le dispositif de la figure 7,
- la figure 23 représente un organigramme d'un autre mode de réalisation du procédé de microtamponnage de la figure 13, et
- la figure 24 est une illustration schématique et en coupe d'un détail d'une variante du dispositif de la figure 7.

Dans ces figures, les mêmes références sont utilisées pour designer les mêmes éléments.

Dans la suite de cette description, les caractéristiques et fonctions bien connues de l'homme du métier ne sont pas décrites en détail.

La figure 7 représente un dispositif 30 de microtamponnage. Le dispositif 30 décrit ici est destiné à imprimer sur un substrat 32 une empreinte dont les motifs doivent avoir des largeurs inférieures à 100 micromètres. Typiquement, la machine décrite ici permet d'obtenir des motifs dont la largeur est inférieure à 1 micromètre ou 500 nm voire même inférieure à 50 nm. A ces échelles, les applications concernent par exemple et de manière non limitative : la micro nanotechnologie, la microélectronique et la microphotonique. Toutefois ce dispositif peut aussi être utilisé pour des applications en micro nano biotechnologie, chimie de surface et microfluidique, qui requièrent des motifs jusqu'à 100 $\mu$m.

Le dispositif 30 est posé sur un plan horizontal X,Y et s'étend vers le haut le long d'une direction verticale Z.

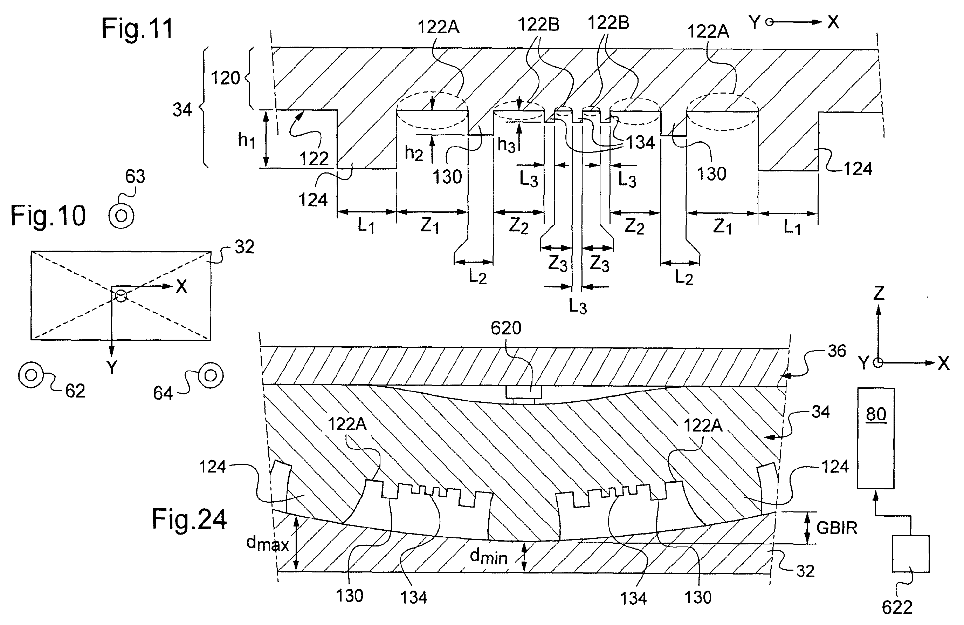

Le dispositif 30 comprend un tampon 34 en matériau élastomère. Le tampon 34 est décrit plus en détail en regard de la figure 11.

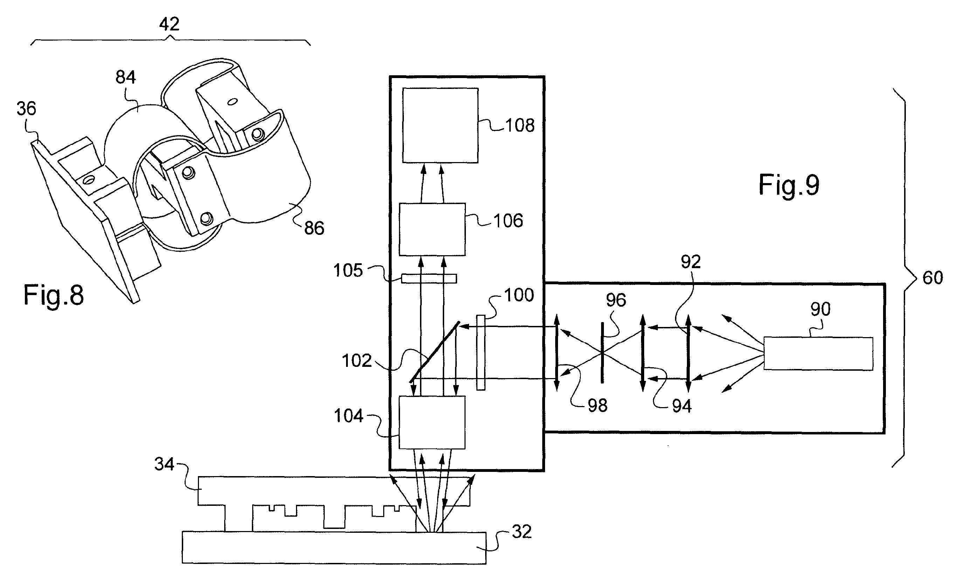

Ce tampon 34 est fixé sans aucun degré de liberté sur un porte-tampon 36 réalisé en matériaux rigides. On désigne ici par « rigide » un matériau dont le module de Young est supérieur à 1 GPa et de préférence supérieur à 60 GPa. Par exemple, ici, le porte-tampon 36 est réalisé en aluminium ou en acier. Le porte-tampon 36 est une plaque rectangulaire qui s'étend essentiellement parallèlement au plan X, Y. Le porte-tampon 36 est fixé à un support rigide coulissant ou chariot 40 par l'intermédiaire d'une articulation 42. L'articulation 42 est décrite plus en détail en regard de la figure 8.

Le chariot 40 est monté à coulissement uniquement dans la direction Z. Pour cela, par exemple, les déplacements du chariot 40 sont guidés par des glissières verticales 44 et 46 de précision. Les glissières verticales 44 et 46 sont fixées à un châssis rigide 48 sans aucun degré de liberté. Le châssis 48 repose sur une surface horizontale.

Le chariot 40 est sollicité vers le haut le long de la direction Z, par un mécanisme de rappel formé ici, par exemple, par deux ressorts 50 et 52 de rappel.

Le déplacement vers le bas du chariot 40 le long de la direction Z est commandé, par exemple, par un vérin pneumatique commandable 54. Ce vérin 54 est propre à solliciter le chariot 40 à l'encontre de la force de rappel des ressorts 50 et 52 pour écraser ou comprimer le tampon 34 contre le substrat 32.

Dans le cas où le tampon 34 est réalisé en matériau transparent à la lumière visible, un capteur 60 d'écarts entre le tampon 34 et le substrat 32 est installé dans le chariot 40. Un exemple d'un tel capteur 60 est décrit plus en détail en regard de la figure 9.

Le dispositif 30 comprend également un mécanisme de butée formé ici par trois butées motorisées 62 à 64 s'étendant le long de la direction Z. Une extrémité de chacune des butées est fixée, sans aucun degré de liberté, sur un épaulement 66 du châssis 48. Le ou les épaulements 66 sont répartis dans un plan horizontal. L'extrémité opposée de ces butées 62 à 64 est apte à venir directement en appui sur le porte-tampon 36 lorsque celui-ci est déplacé vers le bas. La hauteur de chacune de ces butées est réglable. A cet effet, chacune de ces butées comprend un actionneur commandable qui permet de régler la hauteur de chacune des butées avec une résolution du mouvement dans la direction Z au moins inférieure à $h_n/2$. Typiquement, cette résolution est inférieure à $h_n/5$ et de préférence inférieure à $h_n/10$. Par exemple, la résolution du mouvement des butées dans la direction Z est comprise entre 1 nm et 10 nm. Ici, les actionneurs sont des actionneurs piézoélectriques.

Ce mécanisme de butée permet de régler très finement la charge ou la force exercée par le vérin 54 sur le tampon 34. En effet, à l'équilibre, la force exercée sur le tampon est fixée par la hauteur des butées 62 à 64. La force exercée par le vérin se répartie entre une première composante sur le tampon 34, indépendante de la poussée exercée par le vérin 54 sur le porte-tampon 36, et une deuxième composante variable sur les butées 62-64. Les butées 62-64 exercent une réaction qui vient automatiquement s'ajouter à la réaction du tampon 34 pour équilibrer la poussée du vérin 54, en compensant aussi toute variation ou fluctuation de cette poussée.

Ce principe permet de réduire de manière considérable la charge exercée sur le tampon lors du contact entre le tampon et le substrat. En effet la charge sur le tampon 34 n'est plus dépendante de la force globale exercée par le vérin 54 sur le porte-tampon 36 mais elle dépend seulement de la hauteur des butées 62-64. Elle peut alors être réglée avec une très grande résolution, définie par la résolution du réglage de déplacement des butées. L'on s'affranchit ainsi de la nécessité de régler la charge exercée par le vérin 54 avec une grande résolution. Au contraire, il est possible d'exercer en permanence une forte poussée, par exemple supérieure à 1 N, sur le porte-tampon 36 alors que le charge est réglée par des actionneurs piézoélectriques. A titre d'exemple, avec un vérin exerçant une charge de 1 N, il est possible de mettre en contact un tampon 34 en PDMS de $50 \times 20 \, mm^2$ avec des hauteurs $h_1$, $h_2$ et $h_3$ égales respectivement à 10 $\mu$m, 1 $\mu$m et 100 nm en utilisant trois actionneurs piézoélectriques de course 20 $\mu$m et de résolution 10 nm. Les hauteurs $h_1$, $h_2$ et $h_3$ sont définies plus en détail en regard de la figure 11.

Le substrat 32 est monté sans aucun degré de liberté sur un porte-substrat 70 horizontal. Le porte-substrat 70 est déplaçable en translation dans les directions X et Y et en rotation autour d'un axe vertical par des actionneurs 72 et 74 commandables.

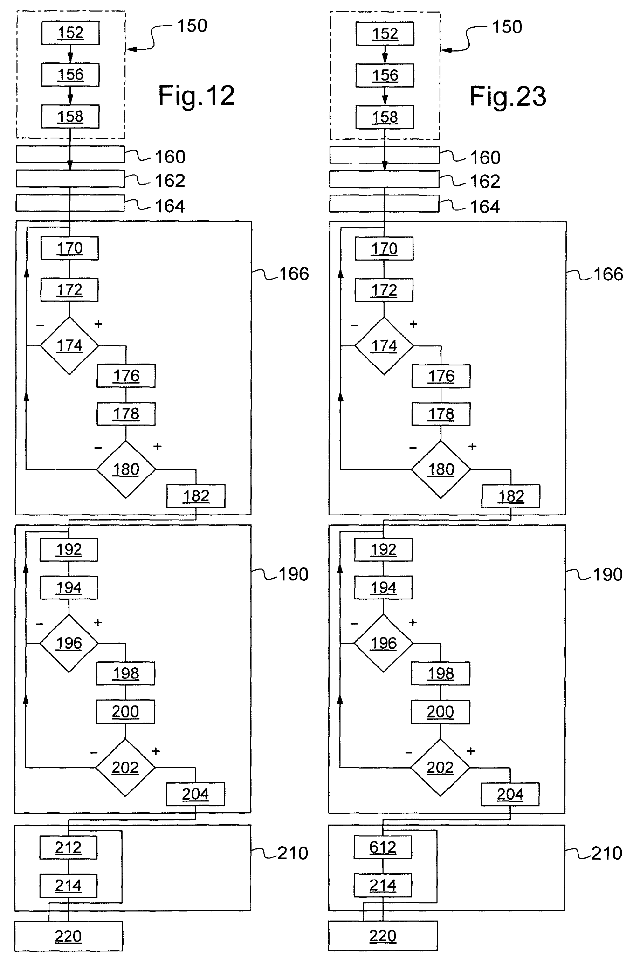

Enfin, le dispositif 30 comprend un calculateur électronique programmable 80 apte à commander le vérin 54 ainsi que les différents actionneurs du dispositif 30 et en particulier les actionneurs des butées 62 à 64. Le calculateur 80 est apte à exécuter des instructions enregistrées sur un support d'enregistrement d'informations. A cet effet, le calculateur 80 est raccordé à une mémoire 82 comportant les instructions nécessaires pour l'exécution du procédé de la figure 12.

La figure 8 représente plus en détail un exemple de mode de réalisation de l'articulation 42. Cette articulation 42 permet au porte-tampon 36 de pivoter autour de n'importe quel axe contenu dans le plan de ce porte-tampon 36. De plus, cette articulation 42 peut s'étendre ou se raccourcir à la manière d'un ressort dans la direction Z. Ici, à titre d'exemple, cette articulation 42 est formée par deux anneaux 84 et 86 réalisés chacun dans un matériau élastiquement déformable. Par exemple, les anneaux 84 et 86 sont réalisés en métal. Chaque anneau s'étend dans un plan vertical respectif. Plus précisément, les anneaux 84 et 86 s'étendent, respectivement, dans des plans verticaux orthogonaux. Les anneaux 84 et 86 sont fixés l'un à l'autre sans aucun degré de liberté.

La figure 9 représente plus en détail un exemple de capteur 60 d'écarts. Ce capteur est conçu pour fonctionner avec un tampon en matériau élastomère transparent à la lumière visible et à faible auto-fluorescence. Par exemple, le matériau utilisé pour réaliser le tampon 34 est du Sylgard 184® vendu par la société Dow Corning. Le tampon 34 comporte des plots. Le capteur 60 mesure, pour chaque plot, le plus petit écart qui sépare son extrémité de la face du substrat. Ces mesures sont donc représentatives du parallélisme entre le fond plat situé entre ces plots et la face en vis-à-vis du substrat 32. Ce capteur permet donc en particulier de détecter le contact d'un plot avec le substrat 32. Ici, l'extrémité de ces plots est recouverte d'un produit fluorescent tel que par exemple le fluorophore CY3.

Le capteur 60 comporte une source de lumière visible 90. La lumière visible émise par cette source 90 est focalisée et concentrée par l'intermédiaire de différentes lentilles 92, 94 puis traverse un diaphragme 96 avant d'être collimatée par une lentille 98. La lumière collimatée traverse enfin un filtre 100 avant d'être réfléchie par un miroir semi-transparent 102 en direction du tampon 34. La lumière fluorescente générée par le fluorophore CY3 traverse un objectif 104 à fort grossissement focalisé sur un point du substrat puis un filtre 105 propre à laisser passer uniquement la lumière générée par le fluorophore CY3. En effet le miroir 102 comporte un traitement de surface qui réfléchit la lumière émise dans la bande passante du filtre 100 et qui laisse passer la lumière émise dans la bande passante du filtre 105 (les deux bandes passantes étant distinctes).

La lumière générée par les fluorophore CY3 après avoir été excitée par la lumière visible traverse l'objectif 104, le miroir 102 puis le filtre 105 pour atteindre un objectif 106 qui concentre cette lumière fluorescente vers un photomultiplicateur 108. Plus un plot recouvert de fluorophore CY3 est proche de la face du substrat, plus l'intensité lumineuse captée par le photomultiplicateur 108 augmente. Cette intensité atteint un maximum lorsqu'un plot recouvert de fluorophore CY3 entre en contact avec le substrat 32,. Ainsi, on mesure l'écart entre l'extrémité d'un plot et on détecte le contact entre ce plot et le substrat 32 à partir de l'intensité lumineuse reçue par le photomultiplier. L'intensité lumineuse mesurée est également proportionnelle à l'aire de la surface du plot en contact avec le substrat 32. Ce capteur 60 permet donc également de mesurer ou d'estimer l'aire de la surface de ce plot qui est en contact avec le substrat 32.

D'autres capteurs d'écarts sont décrits à la fin de cette description.

La figure 10 représente une vue de dessus du substrat 32. Ici, le substrat 32 est une plaque rectangulaire par exemple en silicium. Les butées 62 à 64 sont disposées sur un cercle dont le centre est situé à l'intérieur du pourtour du substrat 32. Par exemple, le centre du cercle sur lesquels sont situées des butées 62 à 64 est confondu avec le centre du substrat 32. Ici, les butées 62 à 64 sont disposées à la même distance les unes des autres.

La figure 11 représente plus en détail une portion en coupe selon le plan X, Z du tampon 34. Typiquement, la portion représentée est répétée plusieurs fois dans la direction X.

Le tampon 34 est ici réalisé dans un matériau élastomère homogène dont le module de Young est compris entre 0,1 MPa et 100 MPa. Par matériau élastomère homogène, on désigne un matériau dont le module de Young est constant dans les directions X, Y et Z. De préférence, le tampon 34 est réalisé dans un matériau élastomère dont le module de Young est compris entre 1 et 10 MPa. Par exemple, ici, le tampon 34 est réalisé en PDMS (poly(diméthylsiloxane)). Plus précisément, le tampon 34 est réalisé dans l'un des matériaux PDMS suivants :

- le sylgard 184 ® dont le module de Young est égal à 1,8 MPa,
- le PDM-h dont le module de Young est égal à 9 MPa,
- le Rhodorsil RTV 3255 de la société Rhodia est égal à 4.4 MPa, et
- le PDM- hυ photodurcissable dont le module de Young est égal à 3,4 MPa après photopolymérisation.

Pour plus de détails sur le PDM-h, le lecteur peut se référer à l'un des articles suivants :

- H. Schmid, B. Michel, Siloxane Polymers for High-Resolution, High-Accuracy Soft Lithography, Macromolecules 2000,33,3042-3049
- Teri W. Odom, J. Christopher Love, Daniel B. Wolfe, Kateri E. Paul, and George M. Whitesides, Improved Pattern Transfer in Soft Lithography Using Composite Stamps, Langmuir, 18 (13), 5314 -5320, 2002

Le tampon 34 est un tampon multiniveau comportant $\underline{n}$ niveaux de motif en relief, où $\underline{n}$ est un entier supérieur ou égal à deux.

Le tampon 34 comporte une couche 120 en PDMS présentant un fond plat 122 tourné vers le substrat 32. Cette couche présente une épaisseur comprise entre 0,1 micromètres et 10 mm, de préférence entre 1 $\mu$m et 1 mm.

$\underline{N}$ niveaux de motif en relief font saillie à partir de la couche 122, où $\underline{n}$ est un entier supérieur à deux. Ces niveaux sont classés par ordre de taille en partant du plus grand vers le plus petit. Chaque niveau est formé de plots ayant tous la même hauteur $h_i$, où l'indice i désigne le niveau de motif, la valeur « 1 » de l'indice i correspondant au niveau de plus grande hauteur. Les plots de chaque niveau i, où i est strictement inférieur à n, délimitent un i-ième fond plat placé entre ces plots. Les plots du niveau i+1 s'étendent perpendiculairement à partir du i-ième fond plat. Le ou les plots du niveau n font saillie à partir d'un n-ième fond plat. Dans le cas du tampon 34, les $\underline{n}$ fonds plats sont confondus les uns avec les autres. La hauteur $h_i$ est mesurée par rapport au i-ième fond plat et perpendiculairement à ce fond plat. La hauteur $h_{i-1}$ est strictement inférieure à la hauteur $h_i$. De préférence, la hauteur $h_{i-1}$ est au moins deux fois inférieures à la hauteur $h_i$ ou au moins dix fois inférieures à la hauteur $h_i$.

Les niveaux i intermédiaire, avec 1 < i <n, permettent d'affiner niveau par niveau l'alignement du tampon par rapport au substrat, ainsi que le réglable du parallélisme du niveau considéré avec le substrat. Grâce au principe des butées, il est possible (i) de mettre en contact simultanément tous les motifs de même hauteur, que le motif soit isolé sur la surface du tampon ou au contraire qu'il constitue une part importante de la surface du tampon, et (ii) d'écraser simultanément tous les motifs de même hauteur.

Ici, tous les plots sont venus de matière avec la couche 120 et forment donc un seul bloc avec cette couche.

Chaque plot comprend des faces latérales sensiblement verticales qui se terminent par une extrémité plane destinée à venir en appui sur le substrat 32.

La section horizontale, c'est-à-dire dans le plan XY, de chaque plot peut être quelconque. Par exemple, cette section peut avoir la forme d'une croix, d'un cercle, d'un carré ou encore d'un rectangle. Lorsque la section est un rectangle très allongée, le plot forme une nervure.

Les plots destinés à déposer de l'encre sur la face du substrat 32 ont un facteur de forme compris entre 0,2 et 2. Le facteur de forme d'un plot est défini par le rapport entre sa hauteur $h_i$ sur sa plus petite largeur $L_i$ . De préférence, ce facteur de forme est égal à un.

Chaque plot de hauteur $h_i$ est entouré d'une zone d'exclusion de largeur $Z_i$. Aucun motif de niveau inférieur ne doit se trouver dans cette zone d'exclusion. En effet, celle-ci est prévue pour absorber les déformations du plot lorsque celui-ci est fortement écrasé contre la face du substrat 32. La plus petite largeur $Z_i$ de la zone d'exclusion est inversement proportionnelle au module d'Young de l'élastomère formant le plot et proportionnelle à la hauteur de compression. La hauteur de compression d'un plot est égale à la différence entre sa hauteur $h_i$ lorsqu'il n'est pas écrasé contre le substrat et la plus petite hauteur atteinte pour ce plot lors du tamponnage.

Par exemple, pour un tampon à deux niveaux, dont le module de Young est égal à 6 MPa, et avec des motifs de hauteur $h_1 = 20$ $\mu$m et $h_2 = 2$ $\mu$m, la largeur $Z_1$ est environ de $15h_1$ soit 300 $\mu$m. Dans ce cas la hauteur de compression des plots du niveau 1 est égale à $h_1 - h_2$.

Ainsi, généralement, la plus petite largeur de la zone d'exclusion $Z_i$ est supérieure à $15h_i$ et, de préférence, supérieur à $25 h_1$.

Par la suite, cette proportion entre la largeur $Z_i$ et la hauteur $h_i$ des plots n'a pas été conservée sur les figures 5 à 24 pour simplifier ces illustrations. Les n-1 premiers niveaux sont appelés « motif de conformation » car ils permettent de paralléliser avec une plus ou moins grande précision le n-ième fond plat avec la surface du substrat. Le n-ième niveau de motif est appelé « motif d'impression » car il permet de réaliser l'empreinte sur le substrat 32.

La figure 11 représente le tampon 34 dans le cas particulier où n est égal à trois.

Le premier niveau est formé de plots 124 de hauteur $h_1$. Les deux plots 124 visibles sur la figure 11 délimitent un premier fond plat 122A qui s'étend entre ces deux plots 124. Le fond plat 122A est ici simplement une zone particulière du fond plat 122.

La hauteur $h_1$ est la plus grande des hauteurs $h_i$. Ce premier niveau permet de paralléliser le fond 122A avec la face du substrat 32. A cet effet, les plots 124 forment au moins trois points d'appui sur la face du substrat 32. Ces points d'appui sont répartis sur des axes non colinéaires et entoure le fond 122A.

Ici, la section horizontale des plots 124 est rectangulaire. Le petit côté de cette section s'étend dans la direction X tandis que le grand coté s'étend dans la direction Y. Le grand coté est, par exemple, trois fois plus long que le petit coté. Dans ces conditions, les points d'appui sont répartis le long de deux axes orthogonaux, respectivement, parallèles aux directions X et Y. Plus précisément, chaque plot 124 forme deux points d'appui alignés le long de l'axe parallèle à la direction Y.

Les faces verticales des deux plots 124 et le fond 122A forment un canal débouchant sur la périphérie du tampon 34. Ainsi, ce canal permet d'éviter que de l'air soit emprisonné entre les plots 124 lorsque ces plots sont écrasés contre le substrat 32.

La hauteur $h_1$ est au moins supérieure à la moitié de la mesure GBIR de la planéité du substrat 32 et, de préférence, supérieure et même plusieurs fois supérieure à cette mesure GBIR.

Ici les plots 124 sont également utilisés pour aligner le tampon 34 par rapport au substrat 32. La position des plots 124, dans un plan horizontal, est donc mesurable à l'aide d'une camera ou de tout autre moyen. A cet effet, pour que la position des plots 124 soient mesurables à l'aide d'une camera, leur plus petite largeur $L_1$ est choisie au moins supérieure à 1 $\mu$m.

Le deuxième niveau de motif en relief est formé de plots 130 de hauteur $h_2$. Il s'agit ici d'un motif intermédiaire de conformation permettant de paralléliser plus précisément un fond plat 122B avec la face du substrat 32. Par exemple, la section horizontale des plots 130 est rectangulaire. Le plus petite coté et le plus grand coté de cette section s'étendent parallèlement, respectivement, aux directions X et Y.

Les faces verticales des deux plots 130 et le fond 122B forment également un canal débouchant sur la périphérie du tampon 34. Ainsi, ce canal permet d'éviter que de l'air soit emprisonné entre les plots 130 lorsque ces plots sont écrasés contre le substrat 32.

La plus petite largeur horizontale des plots 130 est notée $L_2$. De façon similaire au premier niveau, les plots 130 du deuxième niveau de conformation forment au moins trois points d'appui sur la face du substrat 32 répartis sur des axes orthogonaux parallèle aux directions X et Y. Ces points d'appui entourent le deuxième fond plat 122B. Ces plots 130 du deuxième niveau permettent de paralléliser plus finement le fond 122B avec la face du substrat 32.

La hauteur $h_2$ doit être supérieure à la moitié de la mesure SBIR$_{max}$ de la planéité du substrat 32 et, de préférence, supérieure ou plusieurs fois supérieure à cette mesure. Pour la mesure de SBIR$_{max}$ on suppose que la même empreinte est imprimée, à l'aide du tampon 34, dans plusieurs zones d'impression différentes de la face du substrat 32. Chaque site correspond alors à une zone d'impression respective.

Le troisième niveau est formé de plots 134 de hauteur $h_3$ qui font saillie directement à partir du fond 122B. Le troisième fond plat est donc confondu avec le deuxième fond plat. Les plots 134 sont destinés à imprimer l'empreinte sur la face 32. Ici, la section horizontale de ces plots 134, comme celle des plots 130, est choisie pour former avec le fond 122B un canal d'échappement d'air.

La hauteur $h_3$ est supérieure à 0,5 fois la mesure SFQR$_{max}$ de la planéité du substrat 32. De préférence, la hauteur $h_3$ est au moins supérieure à la mesure SFQR$_{max}$ de la planéité du substrat 32. Pour la mesure de SFQR$_{max}$, les sites pris en compte sont les mêmes que pour la mesure SBIR$_{max}$. Ici, la plus petite largeur $L_3$ des plots 134 est égale à la hauteur $h_3$. La section horizontale des plots 134 est par exemple rectangulaire et le plus grand coté de cette section s'étend dans la direction Y.

A titre d'illustration, pour la réalisation d'une empreinte dont le plus petit détail a une largeur d'un micromètre, les hauteurs $h_1$ à $h_3$ sont les suivantes : $h_1 = 50$ $\mu$m, $h_2 = 10$ $\mu$m et $h_3 = 1$ $\mu$m.

Pour la réalisation d'une empreinte dont la largeur du plus petit détail est égale à 10 nm, les hauteurs $h_1$ à $h_3$ sont les suivantes : $h_1 = 1\,000$ nm, $h_2 = 100$ nm et $h_3 = 10$ nm.

Le fonctionnement du dispositif 30 va maintenant être décrit plus en détail en regard du procédé de la figure 12.

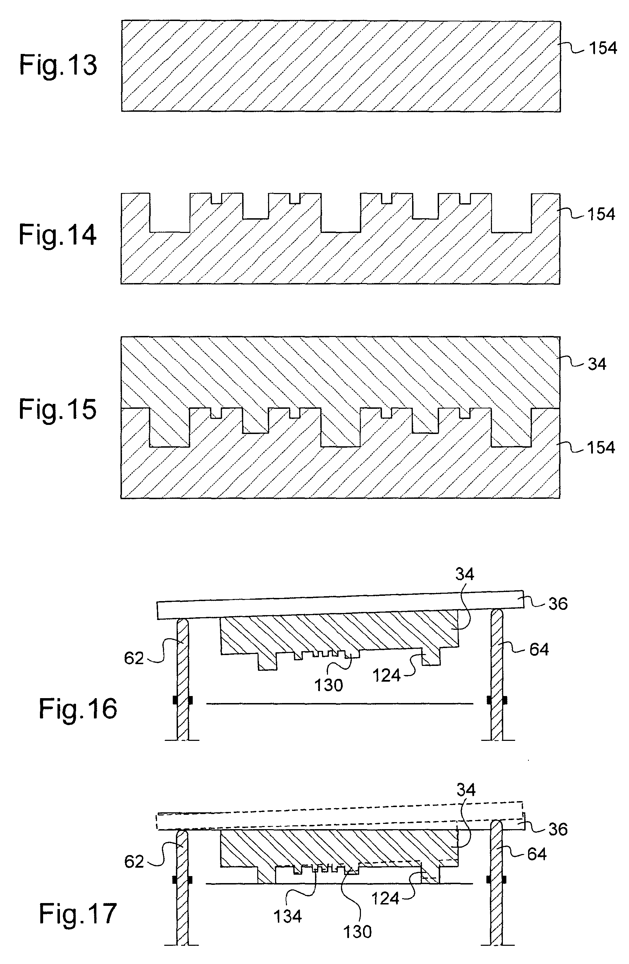

Initialement, on procède à une phase 150 de fabrication du tampon 34. Par exemple, cette phase 150 débute par une étape 152 de fourniture d'un bloc 154 (figure 13) de silicium. Typiquement, la planéité du bloc 154 est au moins égale à celle du substrat 32, et, de préférence, meilleure que celle du substrat 32.

Ensuite, on procède, lors d'une étape 156 à la gravure en négatif des motifs de conformation et d'impression dans la face supérieure du bloc 154. Par exemple, la gravure de ces motifs est réalisée par la méthode RIE (Reactive Ion Etching) car elle permet d'obtenir un facteur de forme plus important, c'est-à-dire supérieur ou égale à 1,5. D'autres méthodes telles que la méthode DRIE (Deep Reactive Ion Etching) ou FIB (Focus Ion Beam) peuvent également être utilisées pour graver les motifs de conformation et d'impression en négatif dans le bloc 154. A l'issue de l'étape 156 un moule ou maître-modèle est obtenu (voir Figure 14).

Ensuite, lors d'une étape 158, le bloc 154 ainsi gravé sert de moule ou de maître-modèle pour réaliser le tampon 34. Par exemple, ici, du PDMS liquide est déversé sur ce moule (voir figure 15). Ensuite, après polymérisation, le bloc en matériau PDMS est séparé du bloc 134 afin d'obtenir le tampon 34. Avantageusement la surface extérieure du bloc 134 peut être modifiée avec un traitement anti-adhésif pour faciliter le démoulage.

Une fois le tampon fabriqué, celui-ci est encré, lors d'une étape 160. Ici, seul le motif d'impression est encré. Par exemple, l'encrage est réalisé par pulvérisation de l'encre sur le motif d'impression ou par explosion d'une goutte d'encre sous vide ou par toute autre méthode appropriée.

L'encre est par exemple du thiol, de l'OTS (octadecyltrichlorosilane), des dendrimères ou des biomolécules telles que de l'ADN, des peptides ou des cellules à déposer sur le substrat 32.

Après l'encrage du tampon 34, lors d'une étape 162, on procède à l'alignement selon les axes X, Y et Z du tampon 34 par rapport au substrat 32. Par exemple, lors de cette étape 162, la position selon les axes X,Y et Z des plots 124 est mesurée. Ensuite, les actionneurs 72 et 74 sont commandés en fonction de ces mesures, par le calculateur 80, pour aligner au moins trois de ces plots 124 sur des cibles portées soit par le substrat 32 soit par le porte-substrat 70.

Lors d'une étape 164, le vérin 54 est commandé pour déplacer le tampon 34 le long de la direction Z jusqu'à ce que le porte-tampon 36 soit en appui sur les trois butées 62 à 64. Initialement, la hauteur des trois butées 62 à 64 est réglée de manière à ce qu'aucun des plots du tampon 34 ne soit en contact avec le substrat 32. Un exemple de position initiale est illustré sur la figure 16.

Ensuite, commence une étape 166 de calibration de la hauteur des butées pour paralléliser grossièrement le fond 122A avec la face du substrat 32.

Lors de toutes les étapes et opérations suivantes de réglage de la hauteur des butées 62 à 64, le porte-tampon 36 est maintenu en appui sur les butées 62 à 64 par le vérin 54.

Par exemple, l'étape 166 débute par une opération 170 de réglage de la hauteur des butées 62 à 64 pour amener le tampon dans une première position d'affleurement potentiel de celui-ci avec la face du substrat 32. Ensuite, le tampon 34 est immobilisé dans cette position en maintenant la hauteur des butées 62 à 64 inchangée.

Lors d'une opération suivante 172, le capteur 60 est mis en oeuvre pour dénombrer le nombre de plots du premier niveau actuellement en contact avec la face supérieure du substrat 32 et pour mesurer l'aire des surfaces des plots en contact avec le substrat 32.

Lors d'une opération 174, la somme des aires mesurées est comparée à la somme des aires des extrémités des plots 124. Si la somme des aires mesurées représente plus de 10 % de la somme des aires des extrémités des plots 124, alors le procédé retourne à l'opération 170 où une nouvelle première position d'affleurement potentiel est réglée à l'aide des butées 62 à 64. En effet, on considère que dans ce cas le parallélisme entre le tampon 34 et le substrat 32 n'est pas suffisamment bon.

Dans le cas contraire, lors d'une opération 176, le calculateur 80 commande une diminution simultanée et à la même vitesse des hauteurs des butées 62 à 64 pour passer de la première position d'affleurement déterminée lors des opérations 170 à 174, à une première position de contact des plots du premier niveau avec le substrat 32. La première position de contact est telle que l'épaisseur $D_1$ de l'espace qui sépare le fond 122A de la face du substrat 32 dans cette position est supérieure à $h_1/2$ et inférieure à $h_1$. De préférence l'épaisseur $D_1$ est comprise entre $h_1/2$ et $9h_1/10$. En effet, pour exercer un bon contact entre un plot et le substrat, la hauteur du plot doit de préférence être diminuée de $h_i/10$ lorsque celui-ci est en contact avec la face du substrat. Typiquement, lors de l'opération 176, la hauteur de chacune des butées est abaissée d'une course $c_1$ supérieure à $h_1/10$ et, en tout état de cause, supérieur à 2 fois la mesure GBIR de la planéité du substrat.

Ensuite, lors d'une opération 178, on mesure à nouveau à l'aide du capteur 60 le nombre de plots 124 en contact avec le substrat 32 et l'aire de ces plots en contact avec le substrat 32.

Lors d'une opération 180, la somme des aires mesurées est comparée à la somme des aires des extrémités des plots 124. Si la somme des aires mesurées est inférieure à 80 % de la somme des aires totales des extrémités des plots 124, alors le procédé retourne à l'opération 170. En effet, cela signifie que le parallélisme entre le tampon et le substrat n'est pas suffisamment bon. Dans le cas contraire, on procède à une opération 182 de mémorisation des dernières positions d'affleurement et de contact trouvées. Lors de l'opération 182 on maintient le tampon 34 dans la première position de contact pendant un temps compris entre 0,5s et 10s.

Un exemple d'une position de contact incorrecte nécessitant un retour à l'opération 170 est représenté en pointillés sur la figure 17. La figure 17 illustre également, en trait plein, un exemple d'une position de contact correcte.

A l'issue de l'opération 182, on procède à une étape 190 de réglage du parallélisme du fond 122B avec la face du substrat 32. Pour cela, lors de l'étape 190, les plots 130 du deuxième niveau de motif de conformation sont utilisés.

L'étape 190 débute par une opération 192 d'abaissement de la hauteur des butées 62 à 64 jusqu'à une deuxième position d'affleurement potentiel où les plots 124 sont écrasés contre la face du substrat 32 tandis que les plots 130 sont proches de cette face mais sans la toucher directement.

Ensuite, on procède à des opérations 194 à 204 respectivement identiques aux opérations 172 à 182 à l'exception du fait que l'on travaille avec les plots 130 au lieu des plots 124.

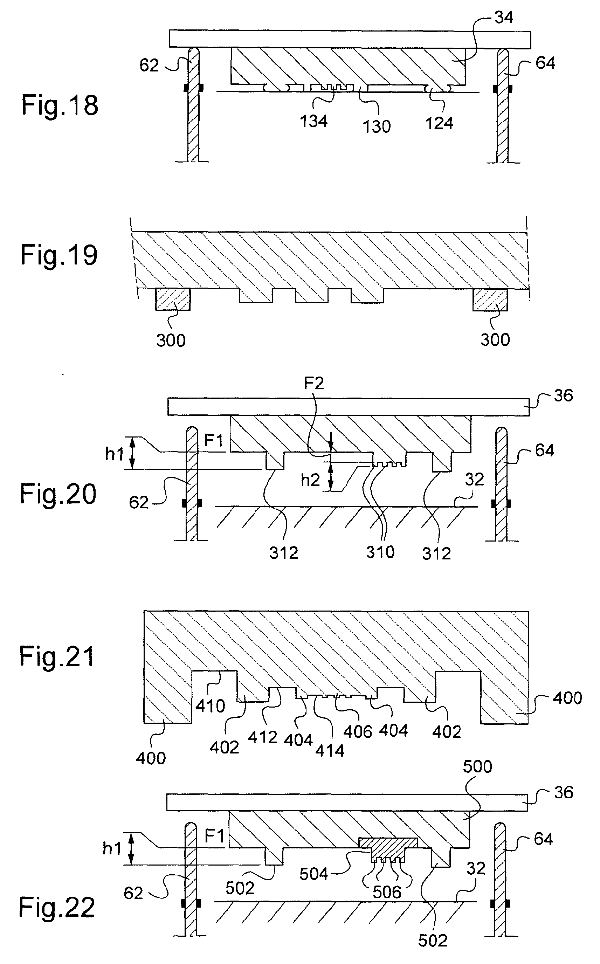

Un exemple de deuxième position d'affleurement correct est représenté sur la figure 18.

A l'issue de l'étape 190, le mouvement du tampon 34 vers le bas est arrêté dans une deuxième position de contact où l'épaisseur $D_2$ de l'espace séparant le fond 122B de la face en vis-à-vis du substrat 32 est comprise entre $h_2/2$ et $9h_2/10$. On maintient le tampon 34 dans cette deuxième position de contact pendant 0,5s à 10s.

Ainsi, avant de procéder au transfert du motif de rang n, le tampon est mis en contact uniquement sur les motifs de hauteur supérieure, de sorte que l'absence de contact du motif de rang n avec le substrat empêche tout échange d'énergie lié au travail d'adhésion des surfaces. Cet échange d'énergie qui est connu pour déformer les motifs d'impression est ainsi limité à la dernière étape du procédé, juste pour la durée nécessaire à l'impression.

On suppose ici que la largeur des plots du motif d'impression est tellement petite que le contact de ces motifs d'impression avec le substrat 32 ne peut pas être détecté à l'aide du capteur 60.

On procède donc, directement à partir de la deuxième position de contact, à une étape 210 d'impression de l'empreinte sur le substrat 32. Au début de cette étape 210, lors d'une opération 212, on abaisse simultanément et à la même vitesse la hauteur des butées 62 à 64 d'une course Δ à partir de la deuxième position de contact pour atteindre directement une troisième position de contact. La troisième position de contact est choisie pour garantir que l'épaisseur $D_3$ de l'espace incompressible entre le fond 122B et la face en vis-à-vis du substrat est comprise entre $h_3/2$ et $9h_3/10$. Ainsi, les plots 134 du motif d'impression sont légèrement compressés contre le substrat 32 mais en aucun cas complètement écrasés contre ce substrat.

A cet effet, par exemple, la course Δ est donnée par la relation suivante :

$$\Delta = 9(h_2 - h_3)/10 + 3 \times SFQR_{max}$$

où $SFQR_{max}$ est la mesure $SFQR_{max}$ de la planéité du substrat.

Cette course permet de garantir que l'épaisseur $D_3$ est comprise entre $h_3/2$ et $9/h_3/10$.

Ensuite, lors d'une opération 214, on maintient le tampon dans cette troisième position de contact pendant un temps variant de 1 milliseconde à 15 minutes et de préférence pendant un temps compris entre 0,5 secondes et 10 secondes.

En fait, le temps pendant lequel le motif d'impression doit être maintenu en contact avec la face du substrat 32 dépend de l'encre et du substrat ainsi que de la matière utilisée pour réaliser le tampon. Le tableau ci-dessous donne quelques exemples de temps de contact en fonction du type d'encre, du tampon et du substrat utilisé :

| Produit à transférer (encre) | Tampon | Substrat | Temps de contact | Référence |
|---|---|---|---|---|
| Octadecyltrichlorosilane (OTS) | PDMS | $SiO_2$/Si A1 | 30 s | Jeon et al. Langmuir, 13 (13), 3382 -3391 (1997) |
| OTS | PDMS | SiO2/S | 5 s | Xia et al. JACS 117, 9576-9577 (1995) |
| n-Alkanethiols de formule générale HS-(CH2)n-CH3 dont : (i) hexadecanethiol (HDT, n=15) (ii)octadecanethiol (ODT, n=17) (iii) eicosanethiol (ECT, n =19) | PDMS | Ag Au | 30 à 120 s | Balmer et al. Langmuir 21, 622-632 (2005) |
| HDT | PDMS | Ag Au | 5 s | Xia et al. Langmuir 12, 4033-4038 (1996) |
| HDT | PDMS | Au | 1 ms | Helmuth et al. JACS., 128, 9296-9297 (2006) |
| Dendrimères | PDMS-h | Pd | 20 s | Jang et al. Langmuir 22, 3326-3331 (2006) |

(suite)

| Produit à transférer (encre) | Tampon | Substrat | Temps de contact | Référence |
|---|---|---|---|---|
| ADN | PDMS | Verre fonctionnalisé chimiquement | 15 s à 2 minutes | Thibault et al. Journal of Nanobiotechnology 3:7 (2005) |
| ADN | PDMS | Verre fonctionnalisé | 15 s | Lange et al. Anal. Chem., 76 (6), 1641 -1647 (2004) |
| Protéines | PDMS | Verre fonctionnalisé | 1-2 minutes | Inwowicz et al. Langmuir 18, 5263-5268 (2002) |
| Protéines | PDMS | | 1 s | Renault et al. J. Phys. Chem. B, 107 (3), 703 -711 (2003) |
| Protéines | Agarose (hydrogel ) | Verre fonctionnalisé | 10 s | Mayer et al. Proteomics 4, 2366-2376 (2004) |
| Cellules | Agarose | Tissu poreux d'hydroxyapatite | 15 minutes | Stevens et al. Biomaterials 26 7636-7641 (2005) |
| Bactéries | Agarose | Surface d'agar | 5 s | Weibel et al. Langmuir 21, 6436-6442 (2005) |

Une fois ce temps de contact écoulé, lors d'une étape 220, le calculateur augmente de nouveau la hauteur des butées 62 à 64 pour ramener le tampon 34 dans sa première position initiale où aucun des plots de ce tampon n'est en contact avec le substrat 32.

De nombreux autres modes de réalisation sont possibles. Par exemple, d'autres matériaux que le PDMS peuvent être utilisés pour réaliser le tampon 34 tel que le poly(butyldiène), le poly(diméthylsiloxane), le poly(acrylamide), le poly(butylstyrène) et leurs copolymères.

Ce qui vient d'être décrit dans le cas de l'application du tampon 34 par un mouvement de translation peut également s'appliquer à un tampon rotatif dans lequel les motifs viennent en contact avec le substrat par un mouvement de rotation autour d'un axe.

Le déplacement du porte-tampon vers le substrat peut aussi être obtenu par déplacement du substrat vers un tampon fixe ou par un mouvement combiné du tampon et du substrat ; les mouvement pouvant être des translations, rotations et/ou une combinaison des deux.

A titre d'exemple le moyen de déplacement du porte-tampon a été décrit ici comme étant un vérin pneumatique. Dans d'autres modes de réalisation ce moyen de déplacement du porte-tampon est un vérin hydraulique ou un axe motorisé avec un moteur pas à pas, à courant continu, linéaire magnétique ou un autre type de moteur connu de l'homme du métier. Le moyen de déplacement peut être à commande manuelle, ou commandé par ordinateur, avec ou sans asservissement en position.

Par ailleurs, le mécanisme de butée réglable peut être commandé ou à réglage manuel. Il peut être constitué de vis micrométriques motorisées avec un moteur pas à pas, ou de tout autre moteur connu de l'homme de l'art, avec ou sans asservissement de position. Il peut être aussi constitués d'actionneurs piézoélectriques motorisés dont la résolution peut atteindre 1 à 10 nm et la course de 1 à 100 $\mu$m (cf. catalogue des sociétés Melles Griot Inc. et Physik Instrument GmbH). Selon un mode de réalisation préférentiel le mécanisme de butée réglable est constitué d'un système mixte : vis micrométriques (à déplacement manuel ou motorisé) pour assurer une grande course et d'un actionneur piézoélectrique, avec capteur de position et boucle d'asservissement intégrés.

Les butées 62 et 64 peuvent être remplacées par un autre mécanisme de butée tel qu'un asservissement en position.

En variante, les butées réglables en hauteur peuvent être solidaires du porte-tampon 36 et venir en appui sur l'épaulement 66 solidaire du châssis 48.

Lorsque le substrat est réalisé dans un matériau transparent à la lumière visible, le capteur 60 peut alors être placé sous le substrat et non pas au-dessus comme décrit dans la figure 7. Ce positionnement est particulièrement adapté aux situations où le substrat est en verre et le tampon est réalisé dans un matériau élastomère non transparent à la lumière visible. Par exemple, le tampon est réalisé en Rhodorsil RTV 3255 de couleur rouge et de module d'Young intermédiaire entre le PDMS-h et le Sylgard 184.

Le capteur 60 mesure l'écart entre le tampon et le substrat sur une partie du tampon et/ou sur une partie du substrat, par exemple sur tout ou partie des motifs de hauteur $h_i$ avec i = 1 à n-1 et sur tout ou partie de la surface du substrat en regard pour en déduire une indication sur le parallélisme entre un i-ième fond plat et le substrat.

Avantageusement le principe de détection est adapté à la résolution du motif de hauteur $h_i$. Il convient alors de changer de principe de détection au fur et à mesure de la mise en contact par écrasement des différents niveaux du tampon. De nombreux capteurs connus de l'homme du métier peuvent être mis en oeuvre dans le dispositif de microtamponnage. A titre d'exemple et de manière non exhaustive, ils peuvent être basés sur une observation directe avec une caméra par réflexion ou transmission, par interférométrie ou effet de moiré, par microscopie confocale ou non, par détection de fluorescence. Une combinaison des ces principes peut aussi être mis en oeuvre, notamment la détection de fluorescence par microscopie confocale. Le contact tampon-substrat peut être détecté en des points localisés par des moyens connus de l'homme du métier, par exemple par effet capacitif, effet tunnel, ou par passage d'un courant électrique.

Avantageusement le porte-substrat est également monté à rotation autour d'axes parallèles respectivement aux directions X et Y. Des actionneurs permettent de régler la position angulaire du porte-substrat autour de ces axes. Ceci permet d'affiner le réglage du parallélisme tampon-substrat.

Le moule utilisé pour réaliser le tampon 134 peut être réalisé en déposant de la matière en surimpression sur une face plane de base. Par exemple cette matière peut être de la résine photopolymérisable négative SU8.

Avantageusement la partie du tampon en contact avec le porte-tampon est moulée avec un logement apte à recevoir le porte-tampon ou une partie en saillie du porte-tampon de manière à établir une liaison mécanique sans degré de liberté entre le tampon et le substrat.

L'encrage du tampon peut être réalisé à différents moments au cours du procédé de microtamponnage. Par exemple, dans un premier temps, on détermine et on mémorise toutes les positions d'affleurement et de contact. Ensuite, le tampon est ramené dans sa position initiale et encré. Lors de cet encrage, les motifs de conformation peuvent aussi être encrés. Après, on déplace successivement le tampon de sa position initiale vers la première position mémorisée d'affleurement puis vers la première position de contact mémorisée suivi d'un arrêt éventuel de 0,5 à 10 secondes puis jusqu'à la deuxième position d'affleurement puis jusqu'à la deuxième position de contact et ainsi de suite jusqu'à ce que le motif d'impression soit mis en contact avec la surface du substrat.

Certains niveaux i du tampon peuvent être métallisés, fonctionnalisés chimiquement, ou encrés différemment du motif d'impression de niveau n, ainsi que la surface en regard du substrat, pour faciliter le réglage du dispositif au niveau i. Par exemple les plots des niveaux i (i < n) du tampon, et éventuellement la surface du substrat en regard, sont métallisés pour créer un champ d'interférence détectable ou encore détecter leur contact par passage d'un courant électrique. Selon une autre variante, ces niveaux peuvent être encrés avec des fluorophores afin de détecter le contact tampon-substrat par émission de fluorescence détectée par microscopie confocale. La détection du contact de ces plots avec le substrat est ensuite utilisée pour régler le parallélisme entre le tampon et le substrat.

Le temps pendant lequel le tampon est maintenu dans chacune des positions de contact n'est pas nécessairement le même d'une position de contact à la suivante. En fait, il est possible de faire varier la durée du contact niveau par niveau.

Avantageusement, tous les tampons mis en oeuvre dans une opération de microtamponnage sont référencés par rapport à une même origine, ce qui facilite la superposition des motifs sur le substrat.

En variante, une opération d'alignement du tampon par rapport au substrat est réalisé dans chaque position d'affleurement d'un motif comportant au moins un plot dont la position selon les axes X et Y peut être mesurée. A cet effet, le dispositif de microtamponnage comprend un ou des capteurs propre à mesurer la position de ce plot selon les axes X, Y. Ensuite l'opération d'alignement consiste à aligner dans le plan X, Y le substrat par rapport au tampon (ou inversement) avant le contact des plots de hauteur $h_i$ du tampon (i=1 à n). Pour ce faire, le calculateur 80 règle la distance tampon-substrat du niveau i à la valeur Di avec $h_i < D_i < 2h_i$. En particulier pour le niveaux i , où i est supérieur à 1, ce réglage implique un frottement des niveaux i-1 à 1 sur le substrat, avec donc éventuellement une zone d'exclusion pour l'impression du motif à définir sur le substrat.

Le motif d'impression peut comporter des plots de positionnement de hauteur $h_n$ mais dont la plus petite largeur est au mois deux fois, et de préférence au moins dix fois, plus grande que la largeur $L_n$. La largeur $L_n$ est suffisante pour que l'écart entre ce plot de positionnement et le substrat 32 puisse être mesuré par le capteur 60. Ainsi, grâce à de tels plots de positionnement, il est possible de procéder au réglage encore plus fin du parallélisme du n-ième fond plat avec la face du substrat 32.

L'articulation 42 peut être remplacée par d'autres articulations connues et, notamment, celles décrites dans les publications suivantes :

- K.-B. Choi and J. J. Lee, Review of Scientific Instruments 76, 075106-6 (2005).
- H. Lan, Y. Ding, H. Liu, and B. Lu, Microelectronic Engineering 84, 684-688 (2007).

Le tampon 34 peut être conçu pour couvrir en une seule fois l'ensemble de la surface à imprimer du substrat 32. A l'inverse, le tampon 34 peut être conçu pour imprimer une empreinte uniquement sur un site particulier $\underline{k}$ de la surface à imprimer. Ensuite, le tampon ou le substrat est déplacé de manière à réaliser la même impression mais sur un autre site particulier du même substrat. Le procédé de microtamponnage est alors plus long que le précédent mais le réglage du parallélisme du tampon par rapport à un site particulier du substrat peut être réalisé site par site ce qui permet une impression plus précise. Par exemple, pour chaque site particulier $\underline{k}$, le parallélisme du tampon et du substrat est réglé en fonction de la valeur $SFQR_k$ et non pas de la valeur $SFQR_{maX}$.

La figure 19 représente une variante dans laquelle les plots 300 du (n-1)-ième niveau de motif sont réalisés en matériau rigide c'est-à-dire dans un matériau dont le module de Young est supérieur à 1 GPa.

Une façon de réduire la largeur $Z_i$ de la zone d'exclusion est de limiter la hauteur de compression nécessaire pour passer d'un niveau à l'autre. Par exemple, la figure 20 représente un tampon multiniveau dans lequel le n-ième fond plat est confondu avec aucun des autres fonds plats délimités par les niveaux de conformation. Sur la figure 20, le tampon est représenté dans le cas particulier où n est égal à deux. Ce tampon présente un premier niveau de motif de conformation formé par des plots 312 et un deuxième niveau de motif d'impression formé par des plots 310. Dans cette variante, le deuxième fond plat, à partir duquel font saillie les plots 310 n'est pas confondu avec le premier fond plat délimité par les plots 312. Ici, le deuxième fond plat et le premier fond plat sont parallèles. Par exemple, sur la figure 20, le deuxième fond plat est espacé du premier fond plat par une distance $F_2$. La distance $F_2$ est telle que la somme de la distance $F_2$ et de la hauteur $h_2$ est strictement inférieure à la hauteur $h_1$ des plots 312.

La hauteur de compression passe ainsi de $h_1$-$h_2$, si le premier et le deuxième fonds plats étaient confondus, à $h_1$-$h_2$-$F_2$. En prenant $h_l$=10 μm, $h_2$=1 μm et $F_2$=7 μm, la hauteur de compression passe de 9 μm à 2 μm seulement, ce qui réduit d'autant la largeur de la zone d'exclusion. Elle reste toutefois supérieure à $h_1$/10 soit 1 μm, pour assurer un bon contact du premier niveau sur toute la surface du tampon.

Cette variante présente aussi l'avantage de limiter la course nécessaire pour appliquer le motif d'impression sur la surface du substrat.

La figure 21 représente un tampon avec trois niveaux de motif de conformation et un niveau de motif d'impression. Sur cette figure, les plots des premier, deuxième et troisième niveaux de motif de conformation portent respectivement les références 400,402 et 404. Les plots du motif d'impression portent la référence 406. Les plots 400, 402 et 404 délimitent, respectivement, des fonds plats 410, 412 et 414. Les fonds plats 410, 412 et 414 sont parallèles les uns aux autres et non pas confondus. Ainsi, le tampon comporte autant de niveaux de fond plat que de niveaux de motif de conformation.

Le tampon 34 n'est pas nécessairement uniquement réalisé en matériau élastomère. En particulier, la couche en matériau élastomère peut être précédée d'autres couches de dureté différente et réalisées dans des matériaux différents.

Le tampon peut être constitué de manière hétérogène avec des élastomères de modules d'Young différents. Par exemple, le tampon est constitué par surmoulage successif des différents élastomères homogènes de dureté différentes. Le tampon peut aussi être constitué par moulage d'un maitre-modèle avec en sus des éléments amovibles enlevés ou ajoutés au cours du moulage de manière analogue à ce qui est pratiqué en plasturgie. Il est possible ainsi de réaliser des niveaux de conformation avec un élastomère à faible module d'Young de façon à limiter la largeur $Z_i$ de la zone d'exclusion et de prévoir des motifs d'impression à fort module d'Young de façon à limiter les déformations pendant le contact, ou encore avec une faible interaction avec la surface du substrat de façon à limiter l'influence du travail d'adhésion. A titre d'exemple, le tampon hétérogène peut être constitué d'une structure sandwich d'élastomère PDMS plus rigide pour la couche d'impression et plus souple pour les motifs de conformation.

Un autre exemple de tampon constitué de manière hétérogène est représenté sur la figure 22.La figure 22 représente un tampon 500 présentant un premier niveau de motif de conformation formé de plots 502 et un motif 504 d'impression formé de plots 506. Dans cette variante le motif d'impression 504 est réalisé dans un matériau élastomère plus dur que le matériau élastomère utilisé pour réaliser le motif de conformation. Par exemple, le matériau élastomère utilisé pour réaliser ce motif d'impression présente un module de Young supérieur à 50 MPa et, de préférence, supérieur à 90 MPa.

La figure 23 représente un procédé d'impression sans contact d'une empreinte sur un substrat par microtamponnage. Le procédé de la figure 23 est, par exemple, identique à celui de la figure 12 à l'exception du fait que l'opération 212 est remplacée par une opération 612. Lors de l'opération 612 la hauteur des butées 62 à 64 est réglée pour maintenir

l'épaisseur $D_3$ de l'espace incompressible entre $h_3 + 1$ nm et $h_3 + 100$ nm. Dans ces conditions, les plots 134 du motif d'impression ne viennent jamais en contact avec la face du substrat. Par contre, l'espace de moins d'une centaine de nanomètres d'épaisseur séparant l'extrémité des plots 134 de la face du substrat est suffisamment petit pour permettre à l'encre de traverser cet espace par diffusion balistique. Ainsi, une empreinte est formée sur la face 32 sans qu'il soit nécessaire pour cela qu'il y ait un contact direct entre les plots du motif d'impression et la face du substrat. Cette façon de procéder évite tout échange d'énergie lié au travail d'adhésion des surfaces. Dès lors les plots du motif d'impression ne sont pas déformés ce qui améliore la qualité de l'empreinte. La durée pendant laquelle l'épaisseur $D_3$ est maintenue est comprise entre une durée minimale nécessaire pour assurer le transfert du motif d'impression sur le substrat et une durée maximale qui conduit à dégrader l'empreinte par diffusion. Cette durée peut être déterminée expérimentalement.

La figure 24 représente une variante du dispositif 30 dans laquelle des butées réglables 620, telles que des actionneurs piézoélectriques, avec un sens de déplacement vertical, sont réparties entre le porte-tampon 36 et le tampon 34. Sur la figure 24 une seule butée réglable 620 a été représentée. Plus précisément, chacune de ces butées présente un point d'appui sur un face du porte-tampon tournée vers le substrat 32 et un autre point d'appui sur la face supérieur du tampon 34. Ainsi, chacune de ces butées est apte à modifier localement la courbure du tampon en faisant varier la distance qui sépare ses points d'appui. Chacune de ces butées est commandable par le calculateur 80.

De plus, le dispositif 30 comporte un capteur 622 de défaut de planéité du substrat 32. Par exemple, ce capteur est apte à mesurer l'amplitude dans la direction Z de chaque défaut de planéité. Ce capteur est également apte à mesurer la position dans le plan X, Y de chacun des défauts de planéité. Le capteur 622 est raccordé au calculateur 80.

Lors du procédé d'impression, le capteur 622 mesure les défauts de planéité du substrat 32 avant d'écraser le tampon 34 contre le substrat 32 ou en même temps que le tampon 34 est écrasé sur le substrat 32. Ensuite, le calculateur 80 règle la hauteur des butées 620 pour adapter la courbure du tampon 34 a la courbure du substrat 32 comme illustré sur la figure 24. Par exemple, a cet effet, les mêmes techniques que celles décrites dans le cas des télescopes à miroir de faible épaisseur, qui sont montés sur un ensemble d'actionneurs piézoélectriques, pour corriger en ligne la courbure des miroirs en fonction de la turbulence de l'atmosphère, sont utilisées.

Ainsi le parallélisme entre le tampon et le substrat peut être amélioré même si les surfaces en regard présentent un grand nombre de pics, de vallées et d'ondulation.

Des butées réglables peuvent aussi être disposées entre le substrat 32 et le porte-substrat 70 de manière à modifier localement la courbure du substrat. Ce qui a été décrit en regard des butées 622 s'applique à l'identique aux butées entre le substrat 32 et le porte-substrat 70.

Les enseignements donnés ici dans le cas particulier de tampon à deux et trois niveaux s'appliquent également à un tampon a plus de trois ou quatre niveaux de motif, voir plus.

Le procédé de microtamponnage sans contact dans lequel le motif d'impression ne vient jamais en contact avec la face du substrat peut être mis en oeuvre indépendamment de l'utilisation d'un tampon multiniveau.

Les butées 62 à 64 réparties sur deux axes non colinéaires, pour le réglage ou la modification simultanée des hauteurs des butées, peuvent être mises en oeuvre indépendamment d'un tampon multiniveau.

De même, l'utilisation de butées réglables entre le porte-tampon et le tampon ou entre le porte-substrat et le substrat peut être mis en oeuvre indépendamment de l'utilisation d'un tampon multiniveau.

De façon plus générale, les caractéristiques de l'une quelconque des revendications indépendantes et, en particulier, les caractéristiques de leurs parties caractérisantes, peuvent être remplacées par les caractéristiques de l'une quelconque des revendications dépendantes.

**Revendications**

1. Dispositif de microtamponnage, ce dispositif comprenant un substrat (32) et un tampon (34) propre à imprimer une empreinte sur une face du substrat (32), ce tampon (34) comprenant :

   - une couche (120) en matériau élastomère présentant un premier fond plat (122A) à partir duquel font saillie $n$ niveaux successifs de motifs en relief classés par ordre décroissant de hauteur $h_i$, où n est un entier supérieur ou égal à deux et l'indice i représente le niveau de motif avec $i$ égal à un pour le motif dont la hauteur $h_i$ est la plus grande,
   - un premier niveau de motif, dit de conformation, permettant de paralléliser grossièrement le premier fond plat (122A) avec la face du substrat (32), ce motif étant composé de plusieurs plots (124) de hauteur $h_1$, ces plots (124) définissant au moins trois points d'appui non colinéaires sur ladite face et autour du premier fond plat (122A), la hauteur $h_1$ étant mesurée par rapport à ce premier fond plat (122A) et dans une direction perpendiculaire à ce premier fond plat, et
   - un n-ième niveau de motif, dit d'impression, apte à venir en contact avec la face du substrat (32), uniquement après que le (n-1)-ième niveau de motif ait été mis en contact avec cette face, pour imprimer l'empreinte sur la face du substrat (32), ce motif étant composé d'un ou plusieurs plots (134) de hauteur $h_n$ faisant saillie perpendiculairement à partir d'un n-ième fond plat (122B) confondu avec ou parallèle au premier fond plat (122A) et situé entre les trois points d'appui du premier niveau de motif, **caractérisé en ce que**, la hauteur $h_n$ est comprise entre 0,5 x $SFQR_{max}$ et $h_{n-1}/2$ où $SFQR_{max}$ (Max Site Front least sQuare site Range) est une mesure normalisée de la planéité du substrat, la hauteur $h_n$ de chaque plot étant mesurée par rapport au n-ième fond plat (122B) et perpendiculairement à ce n-ième fond plat (122B),

- le motif d'impression est réalisé en matériau élastomère dont le module de Young est compris entre 0,1 et 100 MPa, et

- le dispositif comprend un mécanisme de butée propre à maintenir un espace incompressible d'épaisseur $D_n$ entre le n-ième fond plat (122B) et la face du substrat (32) lorsque le tampon est comprimé contre la face du substrat pour imprimer l'empreinte, l'épaisseur On étant comprise entre $h_n/2$ et $h_n$ + 100 nm.

2. Dispositif selon la revendication 1, dans lequel le mécanisme de butée est aussi propre à arrêter le tampon (34) dans une position où un espace d'épaisseur Di sépare, d'un côté, la face du substrat (32) et, de l'autre côté, un i-ième fond plat confondu avec ou parallèle au premier fond plat (122A) et à partir duquel les plots de hauteur $h_i$ du niveau i font saillie, l'épaisseur Di étant comprise entre $h_i/2$ et $h_i$ et i étant compris entre 1 et n-1.

3. Dispositif selon l'une quelconque des revendications précédentes, dans lequel le mécanisme de butée comporte au moins trois butées (62-64) dont les hauteurs sont réglables indépendamment les unes des autres et disposées selon au moins deux axes non colinéaires de manière à ce que le réglage des hauteurs de chaque butée modifie l'inclinaison de tout le tampon (34) par rapport à la face du substrat (32).

4. Dispositif selon la revendication 3, dans lequel le dispositif comporte :

   - un capteur (60) d'écarts propre à détecter ou à mesurer une grandeur représentative du parallélisme d'un i-ième fond plat confondu avec ou parallèle au premier fond plat (122A) et à partir duquel des plots de hauteur $h_i$ du niveau i font saillie, et
   - un calculateur électronique (80) propre à régler automatiquement la hauteur des butées (62-64) en fonction de cet grandeur détectée ou mesurée par le capteur (60) pour paralléliser le i-ième fond plat avec la face du substrat.

5. Dispositif selon l'une quelconque des revendications précédentes, dans lequel le dispositif comporte :

   - un porte-tampon (36) sur une face duquel est fixé le tampon (34) ou un porte-substrat (70) sur une face duquel est fixé le substrat (32), le porte-tampon et le porte-substrat ayant un module de Young supérieur à 1 GPa,
   - au moins une butée commandable (620) en appui d'un côté sur ladite face du porte-tampon (36) et de l'autre côté sur le tampon (34) ou d'un côté sur ladite face du substrat (32) et de l'autre côté sur le porte-substrat (70), cette butée étant apte à déformer localement au niveau des points d'appui, avec une amplitude réglable, la courbure du tampon ou du substrat dans une direction parallèle à la direction de compression du tampon sur le substrat,
   - un capteur (622) de défaut de planéité de la face du substrat sur laquelle l'empreinte doit être imprimée ou défaut de planéité de la face du tampon portant le motif d'impression, et
   - un calculateur (80) propre à commander la butée en fonction des mesures du capteur de défaut de planéité pour régler l'amplitude de la déformation locale en fonction du défaut de planéité.

6. Tampon comprenant :

   - une couche (120) en matériau élastomère présentant un premier fond plat (122A) à partir duquel font saillie n niveaux successifs de motifs en relief classés par ordre décroissant de hauteur $h_i$, où n est un entier supérieur ou égal à deux et l'indice i représente le niveau de motif avec i égal à un pour le motif avec la hauteur $h_i$ la plus grande,
   - un premier niveau de motif, dit de conformation, permettant de paralléliser grossièrement le premier fond plat (122A) avec la face du substrat (32), ce motif étant composé de plusieurs plots (124) de hauteur $h_1$, ces plots (124) définissant au moins trois points d'appui non colinéaires sur ladite face et autour du premier fond plat (122A), la hauteur $h_1$ étant mesurée par rapport à ce premier fond plat (122A) et dans une direction perpendiculaire à ce premier fond plat, et
   - un n-ième niveau de motif, dit d'impression, apte à venir en contact avec la face du substrat (32), uniquement après que le (n-1)-ième niveau de motif ait été mis en contact avec cette face, pour imprimer l'empreinte sur la face du substrat (32), ce motif étant composé d'un ou plusieurs plots (134) de hauteur $h_n$ faisant saillie perpendiculairement à partir d'un n-ième fond plat (122B) confondu avec ou parallèle au premier fond plat (122A) et situé entre les trois points d'appui du premier niveau de motif, **caractérisé en ce que** la hauteur $h_n$ est comprise entre 0,5 x $SFQR_{max}$ et $h_{n-1}/2$ où $SFQR_{max}$ (Max Site Front least sQuare focal plane Range) est une mesure normalisée de la planéité du substrat, la hauteur $h_n$ de chaque plot étant mesurée par rapport au n-ième fond plat (122B) et perpendiculairement à ce n-ième fond plat (122B), et le motif d'impression est réalisé en matériau élastomère dont le module de Young est compris entre 0,1 et 100 MPa.

7. Tampon selon la revendication 6, dans lequel le tampon comprend au moins un niveau intermédiaire $i$ de motifs de conformation permettant de paralléliser plus précisément le n-ième fond plat (122B) avec la face du substrat sur laquelle l'empreinte doit être imprimée, chaque niveau intermédiaire $i$ étant composé de plusieurs plots (130) de hauteur $h_i$ supérieure à la mesure $SBIR_{max}$ (Max Site Backside Ideal focal plane Range) normalisée de la planéité du substrat et inférieure à $h_{i-1}/2$ où $h_{i-1}$ est la hauteur des plots du niveau i-1 juste supérieur de motif de conformation, ces plots définissant au moins trois points d'appui non colinéaires disposés autour du n-ième fond plat (122B).

8. Tampon selon la revendication 6 ou 7, dans lequel le tampon comporte au moins un canal d'échappement d'air reliant un espace, situé entre les plots de chaque niveau de motif, à l'extérieur du tampon afin de permettre à l'air susceptible d'être emprisonné entre le substrat et le tampon de s'échapper à l'extérieur du tampon lorsque le tampon est poussé contre la face du substrat.

9. Tampon selon l'une quelconque des revendications 6 à 8, dans lequel la hauteur $h_n$ est inférieure ou égale à 100 micromètres, et de préférence inférieure ou égale à 1 micromètre ou à 0,3 micromètre.

10. Procédé d'impression sans contact d'une empreinte sur la face d'un substrat par microtamponnage à l'aide d'un dispositif conforme à l'une quelconque des revendications 1 à 5, **caractérisé en ce qu'**il comprend :

   • le maintien (612, 214) d'un espace incompressible d'épaisseur $D_n$ entre le n-ième fond plat et la face du substrat lorsque le tampon est comprimé contre la face du substrat pour imprimer l'empreinte, l'épaisseur $D_n$ étant comprise entre $h_n$ + 1 nm et $h_n$ + 100 nm pour permettre à une encre déposée sur l'extrémité de chaque plot du motif d'impression de traverser cet espace incompressible d'épaisseur $D_n$, puis
   • l'éloignement (220) du tampon de la face du substrat sans que le ou les plots du motif d'impression aient été mis directement en contact avec la face du substrat.

11. Procédé d'impression d'une empreinte sur la face d'un substrat par microtamponnage à l'aide d'un dispositif conforme à l'une quelconque des revendications 1 à 5, **caractérisé en ce que** le procédé comprend :

   - le réglage (182) du mécanisme de butée pour arrêter la compression du tampon sur le substrat dans une première position où l'un des niveaux de motif de conformation est directement en appui sur la face du substrat alors que le n-ième fond plat est séparé de la face du substrat par une distance strictement supérieure à $h_n$ + 100 nm, puis
   - le réglage (212 ; 612) du mécanisme de butée pour que la compression du tampon sur le substrat puisse se poursuivre jusqu'à une seconde position où le n-ième fond plat est espacé de la face du substrat par l'espace incompressible d'épaisseur $D_n$.

12. Procédé selon la revendication 11, dans lequel, avant la mise en contact des plots d'un niveau i de motif, le procédé comporte :

   • le maintien (190) en appui sur la face du substrat des plots du niveau i-1, et en même temps
   • le réglage (190) de la hauteur de chaque butée motorisée du mécanisme de butée pour paralléliser le i-ième fond plat délimité par les plots du niveau $i$ de motif, avec la face du substrat.

13. Procédé selon la revendication 11 ou 12, dans lequel le procédé comporte :

   - la détection ou la mesure d'une grandeur représentative du parallélisme d'un i-ième fond plat confondu avec ou parallèle au premier fond plat (122A) et à partir duquel des plots de hauteur $h_i$ du niveau i font saillie, et
   - le réglage (170) de la hauteur de chaque butée motorisée en fonction de la grandeur détectée ou mesurée pour paralléliser le i-ième fond plat avec la face du substrat.

**Patentansprüche**

1. Mikrotampondruckvorrichtung, wobei diese Vorrichtung ein Substrat (32) und einen Tampon (34) umfasst, der geeignet ist, einen Abdruck auf eine Fläche des Substrats (32) zu drucken, wobei dieser Tampon (34) umfasst:

   - eine Schicht (120) aus elastomerem Material, die eine erste ebene Unterseite (122A) aufweist, von der n aufeinanderfolgende Reliefmusterniveaus abstehen, die in absteigender Reihenfolge einer Höhe $h_i$ geordnet sind, wobei n eine ganze Zahl größer oder gleich zwei ist, und der Index i das Musterniveau repräsentiert, wobei i gleich eins ist für das Muster, dessen Höhe $h_i$ die größte ist,
   - ein erstes Musterniveau, welches als Konformationsmusterniveau bezeichnet wird, das gestattet, die erste ebene Unterseite (122A) mit der Fläche des Substrats (32) ungefähr zu parallelisieren, wobei dieses Muster aus mehreren Plotstempeln (124) mit einer Höhe $h_i$ besteht, wobei diese Plotstempel (124) mindestens drei nicht-kollineare Auflagepunkte auf der Fläche und rund um die erste ebene Unterseite (122A) definieren, wobei die Höhe $h_i$ in Bezug auf diese erste ebene Unterseite (122A) und in einer Richtung rechtwinklig zu dieser ersten ebenen Unterseite gemessen wird, und
   - ein n-tes Musterniveau, welches als Druckmusterniveau bezeichnet wird, das geeignet ist, mit der Fläche des Substrats (32) in Kontakt zu gelangen, einzig nachdem das (n-1)-te Musterniveau mit dieser Fläche in Kontakt gebracht wurde, um den Abdruck auf die Fläche des Substrats (32) zu drucken, wobei dieses Muster aus einem oder mehreren Plotstempeln (134) mit einer Höhe $h_n$ gebildet ist, die rechtwinklig von einer n-ten ebenen Unterseite (122B) abstehen, die einteilig mit oder parallel zu der ersten ebenen Unterseite (122A) ist und zwischen den drei Auflagepunkten des ersten Musterniveaus angeordnet ist, **dadurch gekennzeichnet, dass** die Höhe $h_n$ zwischen 0,5 x $SFQR_{max}$ und $h_{n-1}/2$ liegt,

   wobei $SFQR_{max}$ (Max Site Front least sQuare site Range) ein normalisiertes Maß der Planarität des Substrats ist, wobei die Höhe $h_n$ jedes Plotstempels in Bezug auf die n-te ebene Unterseite (122B) und rechtwinklig zu dieser n-ten ebenen Unterseite (122B) gemessen wird,

   - das Druckmuster aus einem elastomeren Material hergestellt ist, dessen Youngscher Modul zwischen 0,1 und 100 MPa liegt, und
   - die Vorrichtung einen Anschlagmechanismus umfasst, der geeignet ist, einen nicht-zusammendrückbaren Raum mit einer Dicke $D_n$ zwischen der n-ten ebenen Unterseite (122B) und der Fläche des Substrats (32) aufrechtzuerhalten, wenn der Tampon gegen die Fläche des Substrats gedrückt wird, um einen Abdruck zu drucken, wobei die Dicke $D_n$ zwischen $h_n/2$ und $h_n$ + 100 nm liegt.

2. Vorrichtung nach Anspruch 1, wobei der Anschlagmechanismus auch geeignet ist, den Tampon (34) in einer Position zu arretieren, wo ein Raum mit einer Dicke $D_i$ auf einer Seite die Fläche des Substrats (32) und auf der anderen Seite eine i-te ebene Unterseite, die einteilig mit oder parallel zu der ersten ebenen Unterseite (122A) ist und von der die Plotstempel mit einer Höhe $h_i$ des Niveaus i abstehen, abtrennt, wobei die Dicke $D_i$ zwischen $h_i/2$ und $h_i$ liegt, und i zwischen 1 und n-1 liegt.

3. Vorrichtung nach einem der vorhergehenden Ansprüche, wobei der Anschlagmechanismus mindestens drei Anschläge (62 bis 64) umfasst, deren Höhen unabhängig voneinander einstellbar sind und die auf mindestens zwei nichtkollinearen Achsen derart angeordnet sind, dass die Einstellung der Höhen jedes Anschlags die Neigung des gesamten Tampons (34) in Bezug auf die Fläche des Substrats (32) modifiziert.

4. Vorrichtung nach Anspruch 3, wobei die Vorrichtung umfasst:

   - einen Abstandssensor (60), der geeignet ist, eine Größe zu erfassen oder zu messen, die für den Parallelismus einer i-ten ebenen Unterseite, die einteilig mit oder parallel zu der ersten ebenen Unterseite (122A) ist und von der die Plotstempel mit der Höhe $h_i$ des Niveaus i abstehen, repräsentativ ist und
   - einen elektronischen Rechner (80), der geeignet ist, automatisch die Höhe der Anschläge (62 bis 64) entsprechend dieser Größe einzustellen, die von dem Sensor (60) erfasst oder gemessen wurde, um die i-te ebene Unterseite mit der Fläche des Substrats zu parallelisieren.

5. Vorrichtung nach einem der vorhergehenden Ansprüche, wobei die Vorrichtung umfasst:

   - einen Tamponträger (36) auf einer Fläche, an welcher der Tampon (34) befestigt ist, oder einen Substratträger (70) auf einer Fläche, an der das Substrat (32) befestigt ist, wobei der Tamponträger und der Substratträger einen Youngschen Modul von mehr als 1 GPa aufweisen,
- mindestens einen steuerbaren Anschlag (620) in Anlage auf einer Seite an der Fläche des Tamponträgers (36) und auf der anderen Seite an dem Tampon (34) oder auf einer Seite an der Fläche des Substrats (32) und auf der anderen Seite an dem Substratträger (70), wobei dieser Anschlag geeignet ist, lokal auf dem Niveau der Auflagepunkte, mit einer einstellbaren Amplitude, die Krümmung des Tampons oder des Substrats in einer Richtung parallel zu der Kompressionsrichtung des Tampons auf dem Substrat zu verformen,
- einen Sensor (622) für einen Planaritätsdefekt der Fläche des Substrats, auf welcher der Abdruck gedruckt werden muss, oder einen Planaritätsdefekt der Fläche des Tampons, der das Druckmuster trägt, und
- einen Rechner (80), der geeignet ist, den Anschlag entsprechend den Messungen des Planaritätsdefektsensors zu steuern, um die Amplitude der lokalen Verformung entsprechend dem Planaritätsdefekt einzustellen.

6. Tampon, umfassend:

- eine Schicht (120) aus elastomerem Material, die eine erste ebene Unterseite (122A) aufweist, von der $\underline{n}$ aufeinanderfolgende Reliefmusterniveaus abstehen, die in absteigender Reihenfolge einer Höhe $h_i$ geordnet sind, wobei n eine ganze Zahl größer oder gleich zwei ist, und der Index i das Musterniveau repräsentiert, wobei $\underline{i}$ gleich eins ist für das Muster, dessen Höhe $h_i$ die größte ist,
- ein erstes Musterniveau, welches als Konformationsmusterniveau bezeichnet wird, das gestattet, die erste ebene Unterseite (122A) mit der Fläche des Substrats (32) ungefähr zu parallelisieren, wobei dieses Muster aus mehreren Plotstempeln (124) mit einer Höhe $h_i$ besteht, wobei diese Plotstempel (124) mindestens drei nicht-kollineare Auflagepunkte auf der Fläche und rund um die erste ebene Unterseite (122A) definieren, wobei die Höhe $h_i$ in Bezug auf diese erste ebene Unterseite (122A) und in einer Richtung rechtwinklig zu dieser ersten ebenen Unterseite gemessen wird, und
- ein n-tes Musterniveau, welches als Druckmusterniveau bezeichnet wird, das geeignet ist, mit der Fläche des Substrats (32) in Kontakt zu gelangen, einzig nachdem das (n-1)-te Musterniveau mit dieser Fläche in Kontakt gebracht wurde, um den Abdruck auf die Fläche des Substrats (32) zu drucken, wobei dieses Muster aus einem oder mehreren Plotstempeln (134) mit einer Höhe $h_n$ gebildet ist, die rechtwinklig von einer n-ten ebenen Unterseite (122B) abstehen, die einteilig mit oder parallel zu der ersten ebenen Unterseite (122A) ist und zwischen den drei Auflagepunkten des ersten Musterniveaus angeordnet ist, **dadurch gekennzeichnet, dass** die Höhe $h_n$ zwischen 0,5 x $SFQR_{max}$ und $h_{n-1}/2$ liegt,

wobei $SFQR_{max}$ (Max Site Front least sQuare focal plane Range) ein normalisiertes Maß der Planarität des Substrats ist, wobei die Höhe $h_n$ jedes Plotstempels in Bezug auf die n-te ebene Unterseite (122B) und rechtwinklig zu dieser n-ten ebenen Unterseite (122B) gemessen wird, und das Druckmuster aus einem elastomeren Material hergestellt ist, dessen Youngscher Modul zwischen 0,1 und 100 MPa liegt.

7. Tampon nach Anspruch 6, wobei der Tampon mindestens ein Zwischenniveau $\underline{i}$ von Konformationsmustern umfasst, das es gestattet, die n-te ebene Unterseite (122B) mit der Fläche des Substrats genauer zu parallelisieren, auf die der Abdruck gedruckt werden muss, wobei jedes Zwischenniveau i aus mehreren Plotstempeln (130) mit einer Höhe $h_i$ besteht, die größer als das normalisierte Maß der Planarität $SBIR_{max}$ (Max Site Backside Ideal focal plane Range) des Substrats und kleiner als $h_{i-1}/2$ ist, wobei $h_{i-1}$ die Höhe der Plotstempel des Niveaus i-1 knapp über dem Konformationsmuster ist, wobei diese Plotstempel mindestens drei nicht-kollineare Auflagepunkte definieren, die rund um die n-te ebene Unterseite (122B) angeordnet sind.

8. Tampon nach Anspruch 6 oder 7, wobei der Tampon mindestens einen Luftabfuhrkanal umfasst, welcher einen Raum, der zwischen den Plotstempeln jedes Musterniveaus angeordnet ist, mit dem Äußeren des Tampons verbindet, um zu gestatten, dass Luft, die dafür empfindlich ist, zwischen dem Substrat und dem Tampon eingeschlossen zu werden, an die Außenseite des Tampons abgeführt wird, wenn der Tampon gegen die Fläche des Substrats gestoßen wird.

9. Tampon nach einem der Ansprüche 6 bis 8, wobei die Höhe $h_n$ kleiner oder gleich 100 Mikrometer ist, und vorzugsweise kleiner oder gleich 1 Mikrometer oder 0,3 Mikrometer.

10. Verfahren zum berührungslosen Drucken eines Abdrucks auf die Fläche eines Substrats durch Mikrotampondruck mit Hilfe einer Vorrichtung nach einem der Ansprüche 1 bis 5, **dadurch gekennzeichnet, dass** dieses umfasst:

- Aufrechterhalten (612, 214) eines nicht-zusammendrückbaren Raums mit einer Dicke $D_n$ zwischen der n-ten ebenen Unterseite und der Fläche des Substrats, wenn der Tampon gegen die Fläche des Substrats gedrückt wird, um den Abdruck zu drucken, wobei die Dicke $D_n$ zwischen $h_n + 1$ nm und $h_n + 100$ nm liegt, um es einem Anker, der an dem Ende jedes Plotstempels des Druckmusters angeordnet ist, zu gestatten, diesen nicht-zusammendrückbaren Raum mit der Dicke $D_n$ zu überqueren, anschließend

- Entfernen (220) des Tampons von der Fläche des Substrats, ohne dass der oder die Plotstempel des Druckmusters direkt mit der Fläche des Substrats in Kontakt gebracht wurden.

11. Verfahren zum Drucken eines Abdrucks auf die Fläche eines Substrats durch Mikrotampondruck mit Hilfe einer Vorrichtung nach einem der Ansprüche 1 bis 5, **dadurch gekennzeichnet, dass** das Verfahren umfasst:

- Einstellen (182) des Anschlagmechanismus, um die Kompression des Tampons auf dem Substrat in einer ersten Position zu arretieren, wo eines der Konformationsmusterniveaus direkt auf der Fläche des Substrats aufliegt, wenn die n-te ebene Unterseite von der Fläche des Substrats mit einer Distanz getrennt ist, die strikt über $h_n + 100$ nm liegt, anschließend
- Einstellen (212; 612) des Anschlagmechanismus, damit die Kompression des Tampons auf dem Substrat sich bis in eine zweite Position fortsetzen kann, wo die n-te ebene Unterseite von der Fläche des Substrats durch den nicht-zusammendrückbaren Raum mit der Dicke $D_n$ beabstandet ist.

12. Verfahren nach Anspruch 11, wobei, vor dem Inkontaktbringen der Plotstempel eines Musterniveaus i, das Verfahren umfasst:

- Halten (190), in Anlage an der Fläche des Substrats, des Plotstempel des Niveaus i-1 und gleichzeitig
- Einstellen (190) der Höhe jedes motorisierten Anschlags des Anschlagmechanismus, um die i-te flache Unterseite, die von den Plotstempeln des Musterniveaus i definiert wird, mit der Fläche des Substrats zu parallelisieren.

13. Verfahren nach Anspruch 11 oder 12, wobei das Verfahren umfasst:

- Erfassen oder Messen einer Größe, die für den Parallelismus einer i-ten ebenen Unterseite, die einteilig mit oder parallel zu der ersten ebenen Unterseite (122A) ist und von der Plotstempel mit einer Höhe $h_i$ des Niveaus i abstehen, repräsentativ ist und
- Einstellen (170) der Höhe jedes motorisierten Anschlags entsprechend der erfassten oder gemessenen Größe, um die i-te ebene Unterseite mit der Fläche des Substrats zu parallelisieren.

**Claims**

1. Microstamping device, this device comprising a substrate (32) and a stamp (34) specifically for printing an imprint on a face of the substrate (32), this stamp (34) comprising:

- a layer (120) of elastomer material having a first flat bottom (122A) from which protrude <u>n</u> successive levels of relief patterns ranked by descending order of height $h_i$, in which n is an integer greater than or equal to 2 and the index <u>i</u> represents the pattern level with i equal to 1 for the pattern whose height $h_i$ is the greatest,
- a first, so-called conformation, pattern level, making it possible to roughly make the first flat bottom (122A) parallel with the face of the substrate (32), this pattern comprising a number of blocks (124) of height $h_i$, these blocks (124) defining at least three non-colinear bearing points on said face and around the first flat bottom (122A), the height $h_i$ being measured relative to this first flat bottom (122A) and in a direction at right angles to this first flat bottom, and
- an n-th, so-called printing, pattern level, capable of coming into contact with the face of the substrate (32), only after the (n-1)th pattern level has been placed in contact with this face, to print the imprint on the face of the substrate (32), this pattern consisting of one or more blocks (134) of height $h_n$ protruding at right angles from an nth flat bottom (122B) coinciding with or parallel to the first flat bottom (122A) and situated between the three bearing points of the first pattern level, **characterized in that**, the height $h_n$ lies between 0.5 x SFQR$_{max}$ and $h_{n-1}/2$

in which SFQR$_{max}$ (Max Site Front least sQuare site Range) is a normalized measurement of the flatness of the substrate, the height $h_n$ of each block being measured relative to the nth flat bottom (122B) and at right angles to this nth flat bottom (122B),

- the print pattern is produced in elastomer material with a Young's modulus of between 0.1 and 100 MPa, and
- the device comprises an abutment mechanism specifically for maintaining a non-compressible space of thickness $D_n$ between the nth flat bottom (122B) and the face of the substrate (32) when the stamp is compressed against the face of the substrate to print the imprint, the thickness $D_n$ lying between $h_n/2$ and $h_n + 100$ nm.

**2.** Device according to Claim 1, in which the abutment mechanism is also specifically for stopping the stamp (34) in a position where a space of thickness $D_i$ separates, on one side, the face of the substrate (32) and, on the other side, an ith flat bottom coinciding with or parallel to the first flat bottom (122A) and from which the blocks of height $h_i$ of level i protrude, the thickness $D_i$ lying between $h_i/2$ and $h_i$ and i lying between 1 and n-1.

**3.** Device according to either one of the preceding claims, in which the abutment mechanism comprises at least three abutments (62, 64) with heights that can be adjusted independently of one another and arranged along at least two non-colinear axes so that the adjustment of the heights of each abutment modifies the inclination of all the stamp (34) relative to the face of the substrate (32).

**4.** Device according to Claim 3, in which the device comprises:

- a deviation sensor (60) specifically for detecting or measuring a quantity representative of the parallel alignment of an ith flat bottom coinciding with or parallel to the first flat bottom (122A) and from which blocks of height $h_i$ of level i protrude, and
- an electronic computer (80) specifically for automatically setting the height of the abutments (62-64) as a function of this quantity detected or measured by the sensor (60) to make the ith flat bottom parallel with the face of the substrate.

**5.** Device according to any one of the preceding claims, in which the device comprises:

- a stamp-holder (36) onto a face of which the stamp (34) is fixed or a substrate-holder (70) onto a face of which the substrate (32) is fixed, the stamp-holder or the substrate-holder having a Young's modulus greater than 1 GPa,
- at least one controllable abutment (620) bearing on one side of said face of the stamp-holder (36) and on the other side on the stamp (34) or on one side of said face of the substrate (32) and on the other side on the substrate-holder (70), this abutment being able to deform locally at the bearing points, with an adjustable amplitude, the curvature of the stamp or of the substrate in a direction parallel to the direction of compression of the stamp on the substrate,
- a sensor (622) of flatness defects of the face of the substrate on which the imprint has to be printed or flatness defect of the face of the stamp bearing the print pattern, and
- a computer (80) specifically for controlling the abutment as a function of the measurements of the flatness defect sensor to adjust the amplitude of the local deformation as a function of the flatness defect.

**6.** Stamp comprising:

- a layer (120) of elastomer material having a first flat bottom (122A) from which protrude n̲ successive levels of relief patterns ranked by descending order of height $h_i$, where n is an integer greater than or equal to 2 and the index i̲ represents the pattern level with i equal to 1 for the pattern with the greatest height $h_i$,
- a first, so-called conformation, pattern level, making it possible to roughly make the first flat bottom (122A) parallel with the face of the substrate (32), this pattern consisting of a number of blocks (124) of height $h_1$, these blocks (124) defining at least three non-colinear bearing points on said face and around the first flat bottom (122A), the height $h_1$ being measured relative to this first flat bottom (122A) and in a direction at right angles to this first flat bottom, and
- an n-th, so-called printing, pattern level, capable of coming into contact with the face of the substrate (32), only after the (n-1)th pattern level has been placed in contact with this face, to print the imprint on the face of the substrate (32), this pattern consisting of one or more blocks (134) of height $h_n$ protruding at right angles from an nth flat bottom (122B) coinciding with or parallel to the first flat bottom (122A) and situated between the three bearing points of the first pattern level, **characterized in that** the height $h_n$ lies between $0.5 \times SFQR_{max}$ and $h_{n-1}/2$

where $SFQR_{max}$ (Max Site Front least sQuare local plane Range) is a normalized measurement of the flatness of the substrate, the height $h_n$ of each block being measured relative to the nth flat bottom (122B) and at right angles to this nth flat bottom (122B),

    - and the print pattern is produced in elastomer material with a Young's modulus of between 0.1 and 100 MPa.

7. Stamp according to Claim 6, in which the stamp comprises at least one intermediate level $i$ of conformation patterns making it possible to more accurately make the nth flat bottom (122B) parallel with the face of the substrate on which the imprint has to be printed, each intermediate level i consisting of a number of blocks (130) of height $h_i$ greater than the normalized $SBIR_{max}$ (Max Site Backside Ideal focal plane Range) measurement of the flatness of the substrate and less than $h_{i-1}/2$ where $h_{i-1}$ is the height of the blocks of the level i-1 just above the conformation pattern, these blocks defining at least three non-colinear bearing points arranged around the nth flat bottom (122B).

8. Stamp according to Claim 6 or 7, in which the stamp comprises at least one air exhaust channel linking a space, situated between the blocks of each pattern level, to the outside of the stamp in order to allow the air likely to be captured between the substrate and the stamp to escape outside the stamp when the stamp is pushed against the face of the substrate.

9. Stamp according to any one of Claims 6 to 8, in which the height $h_n$ is less than or equal to 100 micrometers, and preferably less than or equal to 1 micrometer or 0.3 micrometer.

10. Method for the contactless printing of an imprint on the face of a substrate by microstamping using a device according to any one of Claims 1 to 5, **characterized in that** it comprises:

    • maintaining (612, 214) a non-compressible space of thickness $D_n$ between the nth flat bottom and the face of the substrate when the stamp is compressed against the face of the substrate to print the imprint, the thickness $D_n$ lying between $h_n$ + 1 nm and $h_n$ = 100 nm to allow an ink deposited on the end of each block of the print pattern to pass through this non-compressible space of thickness $D_n$, then
    • separating (220) the stamp from the face of the substrate without the block or blocks of the print pattern having been placed directly in contact with the face of the substrate.

11. Method for printing an imprint on the face of a substrate by microstamping using a device according to any one of Claims 1 to 5, **characterized in that** the method comprises:

    - setting (182) the abutment mechanism to stop the compression of the stamp on the substrate in a first position where one of the conformation pattern levels is directly bearing on the face of the substrate whereas the nth flat bottom is separated from the face of the substrate by a distance strictly greater than $h_n$ + 100 nm, then
    - setting (212; 612) the abutment mechanism for the compression of the stamp on the substrate to be able to continue to a second position where the nth flat bottom is spaced apart from the face of the substrate by the non-compressible space of thickness $D_n$.

12. Method according to Claim 11, in which, before the placement in contact of the blocks of a pattern level i, the method comprises:

    • keeping (190) the blocks of the level i-1 bearing on the face of the substrate, and at the same time
    • setting (190) the height of each motorized abutment of the abutment mechanism to make the ith flat bottom delimited by the blocks of the pattern level $i$ parallel with the face of the substrate.

13. Method according to Claim 11 or 12, in which the method comprises:

    - detecting or measuring a quantity representative of the parallel alignment of an ith flat bottom coinciding with or parallel to the first flat bottom (122A) and from which blocks of height $h_i$ of the level i protrude, and
    - setting (170) the height of each motorized abutment as a function of the quantity detected or measured to make the ith flat bottom parallel with the face of the substrate.

## Fig.1

## Fig.2

## Fig.3

## Fig.4

Fig.5

Fig.6

Fig.7

Fig.8

Fig.9

EP 2 206 016 B1

EP 2 206 016 B1

Fig.11

Fig.10

Fig.24

Fig.12

Fig.23

Fig.13

154

Fig.14

154

Fig.15

34

154

Fig.16

34

36

62

64

130

124

Fig.17

34

36

62

64

134

124

130

Fig.18

Fig.19

Fig.20

Fig.21

Fig.22

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9706012 A
- EP 1726991 A
- WO 02067055 A
- US 5817242 A

**Littérature non-brevet citée dans la description**

- **H. SCHMID ; B. MICHEL.** Siloxane Polymers for High-Resolution, High-Accuracy Soft Lithography. *Macromolecules,* 2000, vol. 33, 3042-3049
- **TERI W. ODOM ; J. CHRISTOPHER LOVE ; DANIEL B. WOLFE ; KATERI E. PAUL ; GEORGE M. WHITESIDES.** Improved Pattern Transfer in Soft Lithography Using Composite Stamps. *Langmuir,* 2002, vol. 18 (13), 5314-5320
- **JEON et al.** *Langmuir,* 1997, vol. 13 (13), 3382-3391
- **XIA et al.** *JACS,* 1995, vol. 117, 9576-9577
- **BALMER et al.** *Langmuir,* 2005, vol. 21, 622-632
- **XIA et al.** *Langmuir,* 1996, vol. 12, 4033-4038
- **HELMUTH et al.** *JACS.,* 2006, vol. 128, 9296-9297
- **JANG et al.** *Langmuir,* 2006, vol. 22, 3326-3331
- **THIBAULT et al.** *Journal of Nanobiotechnology,* 2005, vol. 3, 7
- **LANGE et al.** *Anal. Chem.,* 2004, vol. 76 (6), 1641-1647
- **INWOWICZ et al.** *Langmuir,* 2002, vol. 18, 5263-5268
- **RENAULT et al.** *J. Phys. Chem. B,* 2003, vol. 107 (3), 703-711
- **MAYER et al.** *Proteomics,* 2004, vol. 4, 2366-2376
- **STEVENS et al.** *Biomaterials,* 2005, vol. 26, 7636-7641
- **WEIBEL et al.** *Langmuir,* 2005, vol. 21, 6436-6442
- **K.-B. CHOI ; J. J. LEE.** *Review of Scientific Instruments,* 2005, vol. 76, 075106-6
- **H. LAN ; Y. DING ; H. LIU ; B. LU.** *Microelectronic Engineering,* 2007, vol. 84, 684-688